(19) Europäisches Patentamt
European Patent Office
Office européen des brevets

(11) EP 4 660 705 A1

(12) **EUROPEAN PATENT APPLICATION**
published in accordance with Art. 153(4) EPC

(43) Date of publication:
**10.12.2025 Bulletin 2025/50**

(21) Application number: **24750066.3**

(22) Date of filing: **24.01.2024**

(51) International Patent Classification (IPC):
***G03F 7/038*** *(2006.01)* ***C08G 73/10*** *(2006.01)*
***C08G 73/22*** *(2006.01)* ***G03F 7/027*** *(2006.01)*
***G03F 7/032*** *(2006.01)*

(52) Cooperative Patent Classification (CPC):
**C08G 73/10; C08G 73/22; G03F 7/027; G03F 7/032; G03F 7/038**

(86) International application number:
**PCT/JP2024/001959**

(87) International publication number:
**WO 2024/162116 (08.08.2024 Gazette 2024/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **01.02.2023 JP 2023013845**

(71) Applicant: **Toray Industries, Inc.**
**Tokyo 103-8666 (JP)**

(72) Inventors:
- **KANEKI, Takayuki**
  **Otsu-shi, Shiga 520-8558 (JP)**
- **SHOJI, Yu**
  **Otsu-shi, Shiga 520-8558 (JP)**
- **ARAKI, Hitoshi**
  **Otsu-shi, Shiga 520-8558 (JP)**

(74) Representative: **Hoefer & Partner Patentanwälte mbB**
**Pilgersheimer Straße 20**
**81543 München (DE)**

(54) **NEGATIVE PHOTOSENSITIVE RESIN COMPOSITION, METHOD FOR PRODUCING RELIEF PATTERN USING SAME, CURED ARTICLE AND ELECTRONIC COMPONENT**

(57) Provided is a negative photosensitive resin composition containing: (A) an alkali-soluble resin; (B) a photopolymerization initiator having a photobleaching property; (C) a polymerizable compound; and (D) a sensitizer, in which the (A) alkali-soluble resin contains at least one resin selected from the group consisting of (A-1) a polyimide precursor, (A-2) a polybenzoxazole precursor, and (A-3) a copolymer thereof. The present invention is aimed at providing a photosensitive resin composition that can form a rectangular pattern and yield a film having excellent heat resistance, without the occurrence of undercutting during pattern processing even in the form of a thick film.

EP 4 660 705 A1

## Description

### Technical Field

The present invention relates to: a negative photosensitive resin composition; a method for producing a relief pattern using the same; a cured article; and an electronic component.

### Background Art

Polyimides and polybenzoxazoles have excellent electrical and mechanical properties and a high heat resistance of 300°C or higher, and are, therefore, regarded as useful for applications such as surface protective films of semiconductor elements, interlayer insulating films, and wiring protective insulating films of circuit boards. Further, since resist materials are used for the formation of semiconductor integrated circuits and multilayer printed wiring board circuits, the steps of the formation are complicated and diverse, including film formation on a substrate, exposure of prescribed parts, removal of unnecessary parts by etching or the like, and washing of the substrate surface. Thus, in recent years, for the purpose of reducing the number of such steps, photosensitive resin compositions have been increasingly used as permanent resists that are left intact as insulating materials even after pattern formation.

Many examples of polyimide-containing photosensitive resin compositions have been reported to date. Particularly, there have been proposed polyimide-containing photosensitive resin compositions containing a pre-cyclized polyimide that does not cause curing shrinkage of a film associated with a cyclization reaction of a polyimide precursor into a polyimide, which compositions are capable of forming a film having a high-resolution pattern and excellent heat resistance (see, for example, Patent Literature 1 and 2).

However, in pattern processing of a thick film using such a polyimide-containing photosensitive resin composition described above, due to the high light absorption by the pre-cyclized polyimide, it is difficult to photocure the thick film of the photosensitive resin composition to deep parts in the exposure step of photopatterning. In this case, the pattern formed on the photosensitive resin composition may suffer from a phenomenon called undercutting in which a notch is formed at the bottom end of the pattern. When undercutting occurs, a conductor pattern such as wiring is not sufficiently embedded, and this causes the generation of voids and peeling and cracking of the pattern, resulting in poor conductivity. For elimination of this undercutting, for example, there are technologies that use resins having a high light transmittance as in the inventions disclosed in Patent Literature 3 and 4; however, these photosensitive resin compositions cannot form a rectangular pattern and yield a film having excellent heat resistance.

### Citation List

### Patent Literature

[Patent Literature 1] WO 2006/98291
[Patent Literature 2] JP 2008-281597A
[Patent Literature 3] JP 2004-307710A
[Patent Literature 4] JP 2008-15285A

### Summary of Invention

### Technical Problem

In view of the above-described circumstances, an object of the present invention is to provide a photosensitive resin composition that can form a rectangular pattern and yield a film having excellent heat resistance, without the occurrence of undercutting during pattern processing even in the form of a thick film.

### Solution to Problem

In order to solve the above-described problems, the present invention has the following constitution.

[1] A negative photosensitive resin composition, containing:

(A) an alkali-soluble resin;

(B) a photopolymerization initiator having a photobleaching property;
(C) a polymerizable compound; and
(D) a sensitizer,

wherein the alkali-soluble resin (A) contains at least one resin selected from the group consisting of (A-1) a polyimide precursor, (A-2) a polybenzoxazole precursor, and (A-3) a copolymer thereof.

[2] The negative photosensitive resin composition according to [1], wherein the alkali-soluble resin (A) contains a fluorine atom in an amount of 2 parts by mass to 50 parts by mass with respect to 100 parts by mass of the alkali-soluble resin (A).

[3] The negative photosensitive resin composition according to [1] or [2], wherein the photopolymerization initiator having a photobleaching property (B) has a structure represented by the following Formula (1):

[Chem. 1]

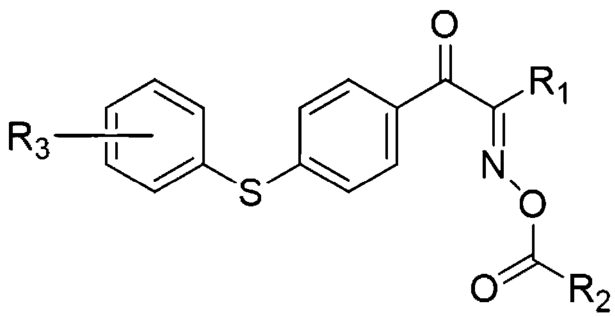

(1)

(in Formula (1), $R_1$ and $R_2$ each independently represent an alkyl group having 1 to 12 carbon atoms, a cycloalkyl group having 4 to 10 carbon atoms, a phenyl group, or a tolyl group; and $R_3$ represents an alkyl group having 0 to 5 carbon atoms, -OH, -COOH, $-O(CH_2)OH$, $-O(CH_2)_2OH$, $-COO(CH_2)OH$, or - $COO(CH_2)_2OH$).

[4] The negative photosensitive resin composition according to any one of [1] to [3], wherein

the polymerizable compound (C) contains (C-1) a polyethylene glycol dimethacrylate represented by the following Formula (2) and (C-2) a polyethylene glycol dimethacrylate represented by the following Formula (3), and

the content of the polyethylene glycol dimethacrylate (C-2) represented by the following Formula (3) is 4 to 20 parts by mass with respect to 100 parts by mass of the polyethylene glycol dimethacrylate (C-1) represented by the following Formula (2):

[Chem. 2]

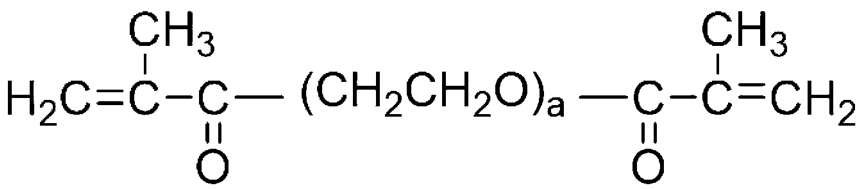

(2)

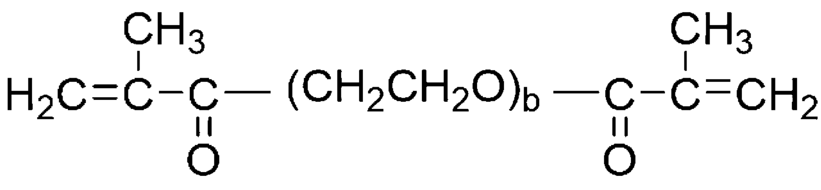

(3)

(in Formula (2), a represents an integer of 4 to 9; and, in Formula (3), b represents an integer of 1 to 3).

[5] The negative photosensitive resin composition according to any one of [1] to [4], wherein

the polymerizable compound (C) contains (C-4) a polyethylene glycol dimethacrylate represented by the following Formula (23) and (C-2) a polyethylene glycol dimethacrylate represented by the following Formula (3), and

the content of the polyethylene glycol dimethacrylate (C-2) represented by the Formula (3) is 15 to 50 parts by mass with respect to 100 parts by mass of the polyethylene glycol dimethacrylate (C-4) represented by the Formula (23):

[Chem. 3]

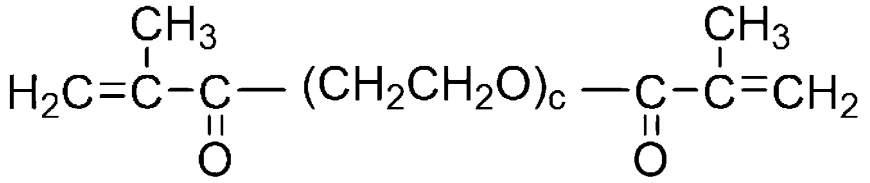 (23)

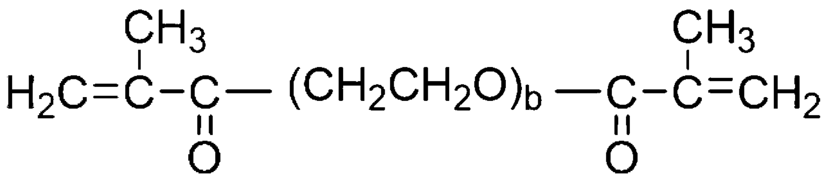 (3)

(in Formula (23), c represents an integer of 9 to 14; and, in Formula (3), b represents an integer of 1 to 3).

[6] The negative photosensitive resin composition according to any one of [1] to [5], wherein, when a polymer of the polymerizable compound (C) is heated from room temperature to 380°C at a heating rate of 10°C/min in a nitrogen atmosphere using a thermogravimetric analyzer, a residual rate after 1-hour heat treatment at 380°C is 10% by mass or less.

[7] The negative photosensitive resin composition according to any one of [1] to [6], wherein

the polymerizable compound (C) contains (C-3) a polymerizable compound having a blocked isocyanate structure, and

the content of the polymerizable compound having a blocked isocyanate structure (C-3) is 0.5 to 15 parts by mass with respect to 100 parts by mass of the (A) alkali-soluble resin.

[8] The negative photosensitive resin composition according to any one of [1] to [7], wherein

the sensitizer (D) contains (D-1) a thioxanthone-based sensitizer, and

the content of the (D-1) thioxanthone-based sensitizer is 5 to 30 parts by mass with respect to 100 parts by mass of the photopolymerization initiator having a photobleaching property (B).

[9] The negative photosensitive resin composition according to any one of [1] to [8], wherein the alkali-soluble resin (A) contains a resin containing a repeating structural unit of the (A-1) polyimide precursor that is represented by the following Formula (4):

[Chem. 4]

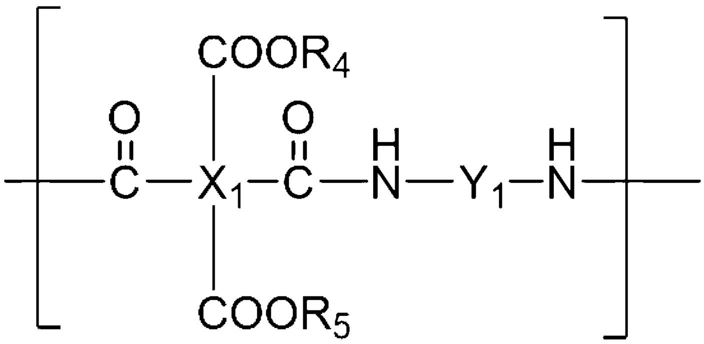

(4)

(in Formula (4), $X_1$ represents a tetravalent organic group having an aliphatic structure having 2 to 20 carbon atoms, an alicyclic structure having 4 to 20 carbon atoms, or an aromatic structure having 4 to 40 carbon atoms; $Y_1$ represents a divalent organic group having a fluorine atom-containing aliphatic structure having 2 to 20 carbon atoms, an alicyclic structure having 4 to 20 carbon atoms, or an aromatic structure having 4 to 40 carbon atoms; plural $R_4$s and $R_5$s are each optionally the same or different; and $R_4$ and $R_5$ each independently represent a hydrogen atom, an alkyl group having 1 to 20 carbon atoms, or an ethylene-type unsaturated double bond-containing monovalent organic group).
[10] The negative photosensitive resin composition according to [9], wherein

the alkali-soluble resin (A) contains the repeating structural unit of the polyimide precursor (A-1) represented by the Formula (4), and
the polyimide precursor (A-1) represented by the Formula (4) has an esterification rate of 40% by mole to 80% by mole.

[11] The negative photosensitive resin composition according to any one of [1] to [8], wherein the alkali-soluble resin (A) contains a repeating structural unit of (A-2) a polybenzoxazole precursor represented by the following Formula (5):

[Chem. 5]

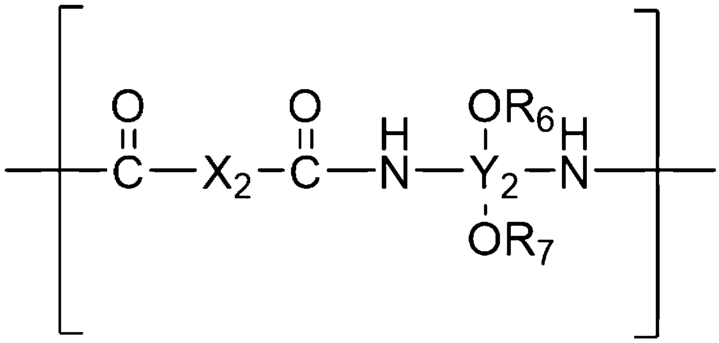

(5)

(in Formula (5), $X_2$ represents a divalent organic group having an aliphatic structure having 2 to 20 carbon atoms, an alicyclic structure having 4 to 20 carbon atoms, or an aromatic structure having 4 to 40 carbon atoms; $Y_2$ represents a tetravalent organic group having an aliphatic structure having 2 to 20 carbon atoms, an alicyclic structure having 4 to 20 carbon atoms, or an aromatic structure having 4 to 40 carbon atoms; at least one of $X_2$ or $Y_2$ has a fluorine atom; and $R_6$ and $R_7$ each independently represent a hydrogen atom, a monovalent alkyl group having 1 to 20 carbon atoms, or an ethylene-type unsaturated double bond-containing monovalent organic group).
[12] The negative photosensitive resin composition according to any one of [1] to [11], containing a compound represented by the following Formula (6):

[Chem. 6]

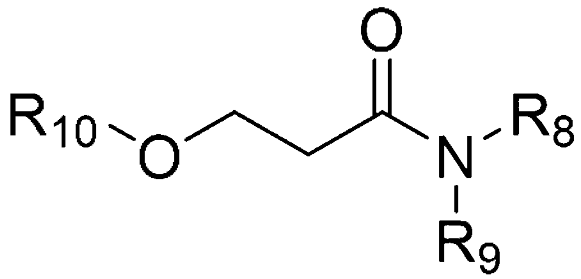

(6)

(in Formula (6), $R_8$, $R_9$, and $R_{10}$ each independently represent an alkyl group having 1 to 6 carbon atoms).

[13] The negative photosensitive resin composition according to [9], wherein

in the Formula (4), $Y_1$ contains a structure represented by the following Formula (7) or a structure represented by the following Formula (8), and

a total content [% by mole] of the structure represented by Formula (7) and the structure represented by Formula (8) is in a range of 70% by mole to 100% by mole in 100% by mole of all diamine residues of the polyimide precursor (A-1) having the repeating structural unit represented by the Formula (4):

[Chem. 7]

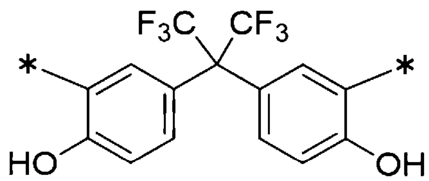

(7)

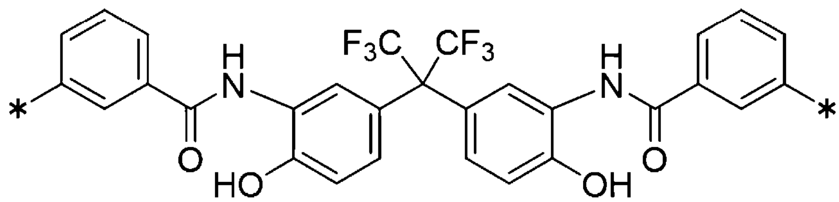

(8)

(in Formulae (7) and (8), * represents a binding site bound to an amide structure).

[14] The negative photosensitive resin composition according to [11], wherein

in the Formula (5), $Y_2$ contains a structure represented by the following Formula (21) or a structure represented by the following Formula (22), and

a total content [% by mole] of the structure represented by Formula (21) and the structure represented by Formula (22) is in a range of 70% by mole to 100% by mole in 100% by mole of all diamine residues of the polybenzoxazole precursor (A-2) having the repeating structural unit represented by the Formula (5):

[Chem. 8]

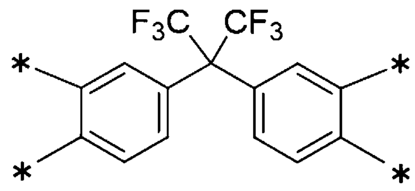

(21)

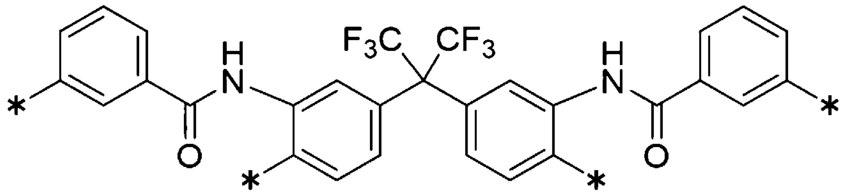

(22)

(in Formulae (21) and (22), * represents a binding site bound to an amide structure or an oxygen atom).

[15] The negative photosensitive resin composition according to [9], wherein, in the Formula (4), $X_1$ contains a structure represented by the following Formula (9) or (10):

[Chem. 9]

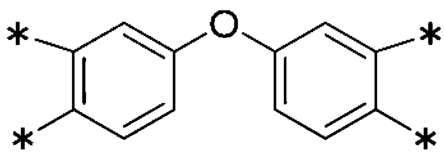

(9)

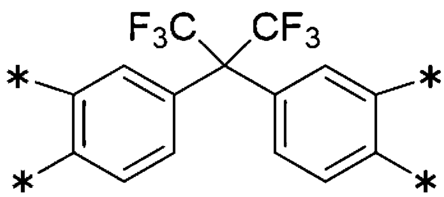

(10)

(in Formulae (9) and (10), * represents a binding site bound to an amide structure, a carboxylic acid structure, or a carboxylic acid ester structure).

[16] The negative photosensitive resin composition according to [11], wherein, in the Formula (5), $X_2$ contains a structure represented by the following Formula (11):

[Chem. 10]

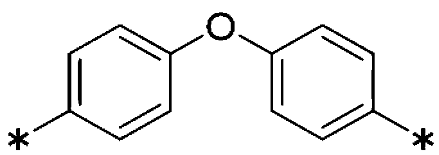

(11)

(in Formula (11), * represents a binding site bound to an amide structure).

[17] A method for producing a relief pattern, the method including the steps of:

applying and drying the negative photosensitive resin composition according to any one of [1] to [16] on a substrate;
performing exposure;
performing development with an alkaline developer; and
performing a heat treatment.

[18] A cured article, obtained by curing the negative photosensitive resin composition according to any one of [1] to [16].
[19] An electronic component, including the cured article according to [18].
[20] The electronic component according to [19], including the cured article on a silicon substrate, a silicon carbide substrate, or a gallium nitride substrate. Advantageous Effects of Invention

According to the present invention, a photosensitive resin composition that can form a rectangular pattern and yield a film having excellent heat resistance, without the occurrence of undercutting during pattern processing even in the form of a thick film.

Description of Embodiments

The negative photosensitive resin composition of the present invention is a negative photosensitive resin composition containing: an alkali-soluble resin (A) (hereinafter, may be referred to as "component (A)"); a photopolymerization initiator having a photobleaching property (B) (hereinafter, may be referred to as "component (B)"); a polymerizable compound (C) (hereinafter, may be referred to as "component (C)"); and a sensitizer (D) (hereinafter, may be referred to as "component (D)"), and
the above-described alkali-soluble resin (A) contains at least one resin selected from the group consisting of (A-1) a polyimide precursor (hereinafter, may be referred to as "component (A-1)"), (A-2) a polybenzoxazole precursor (hereinafter, may be referred to as "component (A-2)"), and (A-3) a copolymer thereof (hereinafter, may be referred to as "component (A-3)").

The above-described configuration allows the negative photosensitive resin composition of the present invention to form a rectangular pattern without the occurrence of undercutting during pattern processing even in the form of a thick film.

The above-described thick film refers to a cured film that is obtained from the negative photosensitive resin composition of the present invention and has a thickness of 15 μm or more. In order to form a film such that it has a post-curing thickness of 15 μm or more, after the step of forming a coating film by applying and drying the negative photosensitive resin composition on a substrate, the resulting coating film needs to have a thickness of about 30 μm or more. In order to process the pattern shape into a rectangle even in thick film processing, the higher the i-line (365 nm) transmittance of the resin composition, the more preferable it is.

Specifically, a coating film obtained by applying the negative photosensitive resin composition and drying it at 100°C for 5 minutes has an i-line transmittance of preferably 20% or more, more preferably 30% or more, still more preferably 50% to 80%, based on a film thickness of 5 μm. When the i-line transmittance is less than 20%, the i-line does not reach a deep part and radicals are not sufficiently generated from the below-described component (B); therefore, for example, undercutting may occur during development, resulting in deterioration of the photosensitive properties.

Further, the i-line transmittance is preferably high after exposure as well. The coating film obtained by applying and drying the negative photosensitive resin composition has an i-line transmittance of preferably 15% or more, more preferably 25% or more, still more preferably 40% to 80%, after being exposed at an i-line equivalent illuminance of 1,000 $mJ/cm^2$. When this i-line transmittance is less than 15%, the i-line does not reach a deep part and radicals are not sufficiently generated from the below-described component (B); therefore, for example, undercutting may occur during development, resulting in deterioration of the photosensitive properties.

The i-line transmittance is measured from a transmitted UV spectrum using a spectrophotometer U-2910 (manufactured by Hitachi High-Tech Science Corporation).

<Alkali-Soluble Resin (A)>

The negative photosensitive resin composition of the present invention contains a component (A). The term "alkali-soluble" used herein refers to a state in which, when a solution obtained by dissolving a resin in γ-butyrolactone (hereinafter, may be abbreviated as "GBL") is applied onto a silicon wafer and this silicon wafer is pre-baked at 120°C for 4 minutes to form a pre-baked film having a film thickness of 10 μm ± 0.5 μm, after which the pre-baked film is immersed in an alkaline aqueous solution selected from a 2.38-wt% tetramethylammonium hydroxide aqueous solution, a 1-wt% potassium hydroxide aqueous solution, and a 1-wt% sodium hydroxide aqueous solution at 23 ± 1°C for 1 minute and then

rinsed with pure water, the dissolution rate determined from the amount of decrease in the film thickness is 50 nm/min or more.

In the present invention, for the purpose of providing such an alkali solubility, the component (A) preferably has an acidic group in a repeating structural unit and/or a main chain end of the resin. Examples of the acidic group include a carboxy group, a phenolic hydroxyl group, and a sulfonic acid group. Further, for the purpose of providing water repellency, the component (A) preferably contains a fluorine atom in an amount of 2 parts by mass to 50 parts by mass with respect to 100 parts by mass of the component (A).

The component (A) contains at least one resin selected from the group consisting of a component (A-1), a component (A-2), and a component (A-3).

From the standpoint of increasing the i-line transmittance in thick film processing and improving the mechanical properties and the heat resistance of the resulting cured film, the component (A) preferably contains the component (A-1), the component (A-2), and/or the component (A-3).

<Polyimide Precursor (A-1)>

Examples of the component (A-1) include products obtained by a reaction between a tetracarboxylic acid, a corresponding tetracarboxylic dianhydride, a tetracarboxylic acid diester dichloride or the like, and a diamine, a corresponding diisocyanate compound, a trimethylsilylated diamine or the like, and the component (A-1) contains a tetracarboxylic acid residue and/or a derivative residue thereof, and a diamine residue and/or a derivative residue thereof. Examples of the component (A-1) include polyamic acids, polyamic acid esters, polyamic acid amides, and polyisoimides.

From the standpoint of improving the storage stability when incorporated into a negative photosensitive resin composition and the standpoint of the miscibility with the below-described components (B) and (C), the component (A-1) preferably contains a polyamic acid ester.

The component (A-1) is a thermosetting resin and, when heat-cured and dehydration-cyclized at a high temperature, forms a highly heat-resistant imide bonds to yield a polyimide. Since the component (A-1) is a resin that improves in heat resistance after being dehydration-cyclized, the component (A-1) is suitable for, for example, the use in applications where the properties of a precursor structure before dehydrative cyclization and the heat resistance of a cured film are both desired to be achieved.

From the standpoint of improving the heat resistance of a cured film, the component (A) preferably contains a resin containing a repeating structural unit of the component (A-1) that is represented by the following Formula (4):

[Chem. 11]

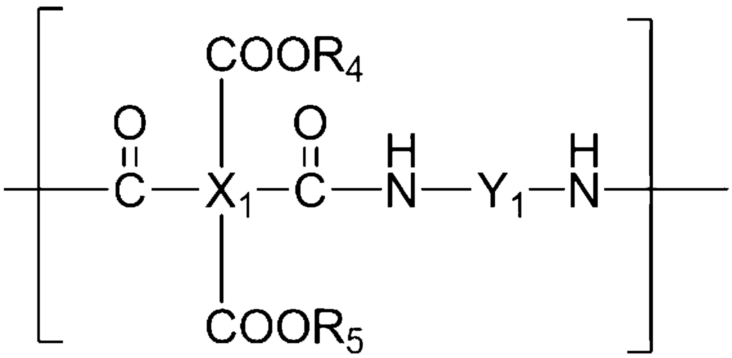

(4)

In Formula (4), $X_1$ represents a tetravalent organic group having an aliphatic structure having 2 to 20 carbon atoms, an alicyclic structure having 4 to 20 carbon atoms, or an aromatic structure having 4 to 40 carbon atoms; $Y_1$ represents a divalent organic group having a fluorine atom-containing aliphatic structure having 2 to 20 carbon atoms, an alicyclic structure having 4 to 20 carbon atoms, or an aromatic structure having 4 to 40 carbon atoms; plural $R_4$s and $R_5$s are each optionally the same or different; and $R_4$ and $R_5$ each independently represent a hydrogen atom, an alkyl group having 1 to 20 carbon atoms, or an ethylene-type unsaturated double bond-containing monovalent organic group.

When a total amount of all polyamic acid repeating structural units and all polyamic acid ester repeating structural units in the component (A-1) is assumed to be 100% by mole, a ratio of all polyamic acid ester repeating structural units in the component (A-1) is defined as the esterification rate of the component (A-1).

In the present invention, the esterification rate is derived from NMR measurement. Specifically, the esterification rate is calculated by a method in which the peak intensity derived from all aromatic ring hydrogens in the polyimide precursor is compared with the peak intensity derived from hydrogens of hydrocarbons directly bound to the ester groups

of all polyamic acid esters in all tetracarboxylic acids and derivative residues thereof as well as all dicarboxylic acids and derivative residues thereof.

From the standpoint of improving the storage stability and the standpoint of the miscibility with the below-described components (B) and (C), the component (A) contains the repeating structural unit of the component (A-1) represented by the Formula (4), and the component (A-1) represented by the Formula (4) has an esterification rate of preferably 40% by mole to 80% by mole, more preferably 65% by mole to 80% by mole.

In Formula (4), $X_1$ represents a tetracarboxylic acid residue and/or a derivative residue thereof, and $Y_1$ represents a diamine residue and/or a derivative residue thereof.

Specific examples of a residue of a tetracarboxylic acid or a derivative thereof include residues of pyromellitic acid, 3,3',4,4'-biphenyltetracarboxylic acid, 2,3,3',4'-biphenyltetracarboxylic acid, 2,2',3,3'-biphenyltetracarboxylic acid, 3,3',4,4'-diphenyl ether tetracarboxylic acid, 3,3',4,4'-benzophenonetetracarboxylic acid, 2,2',3,3'-benzophenonetetracarboxylic acid, 2,2-bis(3,4-dicarboxyphenyl)propane, 2,2-bis(2,3-dicarboxyphenyl)propane, 1,1-bis(3,4-dicarboxyphenyl)ethane, 1,1-bis(2,3-dicarboxyphenyl)ethane, bis(3,4-dicarboxyphenyl) ether, 1,2,5,6-naphthalenetetracarboxylic acid, 9,9-bis(3,4-dicarboxyphenyl)fluorene, 9,9-bis{4-(3,4-dicarboxyphenoxy)phenyl}fluorene, 2,3,6,7-naphthalenetetracarboxylic acid, 2,3,6,7-naphthalenetetracarboxylic acid, 2,3,5,6-pyridinetetracarboxylic acid, 3,4,9,10-perylenetetracarboxylic acid, 2,2-bis(3,4-dicarboxyphenyl)hexafluoropropane, aromatic tetracarboxylic acids having the structures shown below, butanetetracarboxylic acid, cyclobutanetetracarboxylic acid, and 1,2,3,4-cyclopentanetetracarboxylic acid, as well as tetracarboxylic dianhydrides, tetracarboxylic acid dichlorides, and tetracarboxylic acid active diesters thereof. In the component (A-1), these residues may be contained singly, or in combination of two or more thereof.

[Chem. 12]

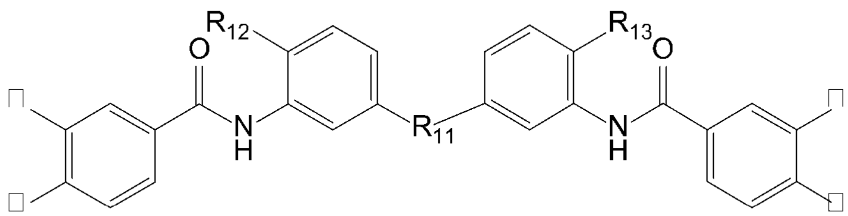

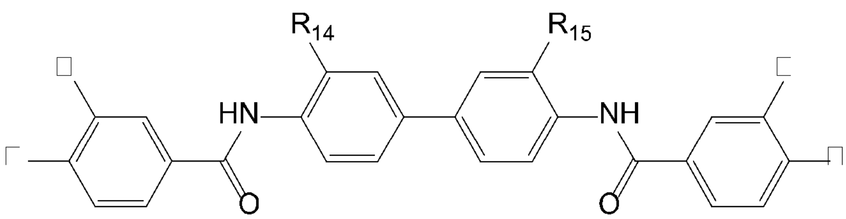

(wherein, $R_{11}$ represents an oxygen atom, $C(CF_3)_2$, or $C(CH_3)_2$; $R_{12}$ to $R_{15}$ each represent a hydrogen atom or a hydroxyl group; and * represents a binding site bound to an amide structure).

When $R_{12}$ to $R_{15}$ are hydroxyl groups and these tetracarboxylic acid residues are introduced into Formula (4), a polyimide precursor that can provide benzoxazole groups is obtained by heat curing.

In the negative photosensitive resin composition, from the standpoint of improving the heat resistance and the i-line transmittance, $X_1$ in Formula (4) preferably contains a structure represented by the following Formula (9) or (10).

[Chem. 13]

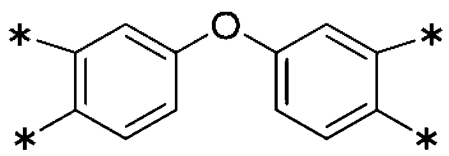

(9)

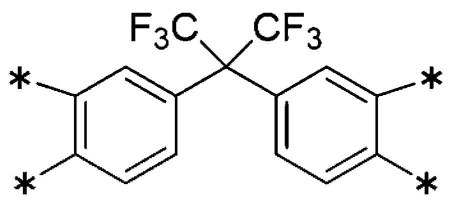

(10)

In Formulae (9) and (10), * represents a binding site bound to an amide structure, a carboxylic acid structure, or a carboxylic acid ester structure.

When $Y_1$ in Formula (4) has a fluorine atom, examples of a residue of a diamine having a fluorine atom or a derivative thereof include residues of 2,2'-bis(trifluoromethyl)-4,4'-diaminobiphenyl, 2,2-bis(4-aminophenyl)hexafluoropropane, 2,2-bis(3-amino-4-hydroxyphenyl)hexafluoropropane, and 2,2-bis[3-(3-aminobenzamido)-4-hydroxyphenyl] hexafluoropropane, as well as compounds in which amine moieties of these residues are isocyanated or trimethylsilylated. In the component (A-1), these residues may be contained singly, or in combination of two or more thereof.

[Chem. 14]

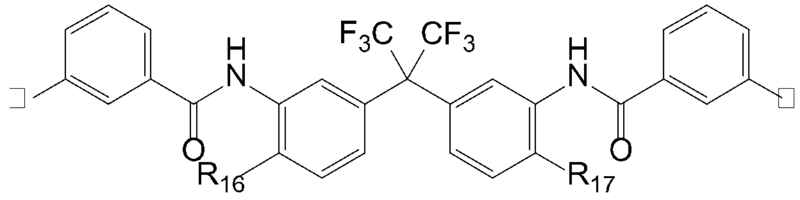

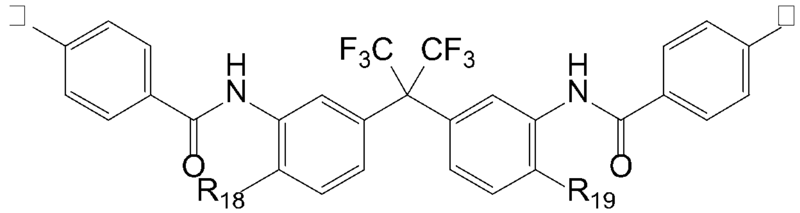

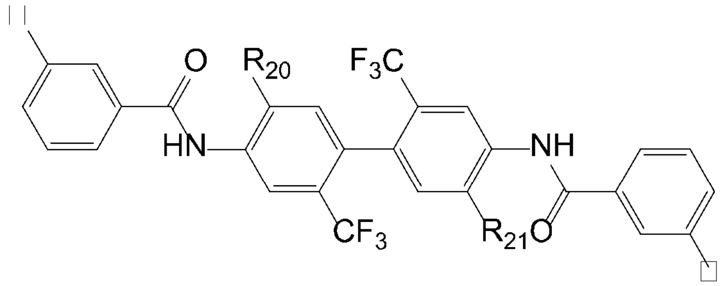

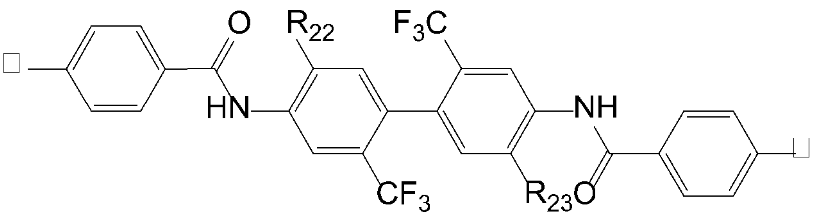

In these formulae, * represents a binding site bound to an amide structure.

In these formulae, $R_{16}$ to $R_{23}$ each represent a hydrogen atom or a hydroxyl group.

In these formulae, when $R_{16}$ to $R_{23}$ are hydroxyl groups and these diamine residues are introduced into Formula (4), a polyimide precursor that can provide benzoxazole groups is obtained by heat curing.

In the negative photosensitive resin composition, from the standpoint of improving the heat resistance and the i-line transmittance, it is preferred that $Y_1$ in Formula (4) contain a structure represented by the following Formula (7) or a structure represented by the following Formula (8), and that a total content [% by mole] of the structure represented by Formula (7) and the structure represented by Formula (8) be in a range of 70% by mole to 100% by mole in 100% by mole of all diamine residues of the polyimide precursor (A-1) having the repeating structural unit represented by Formula (4).

[Chem. 15]

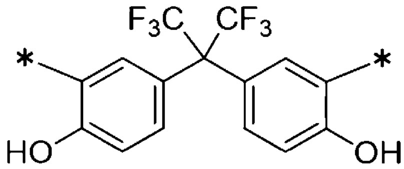

(7)

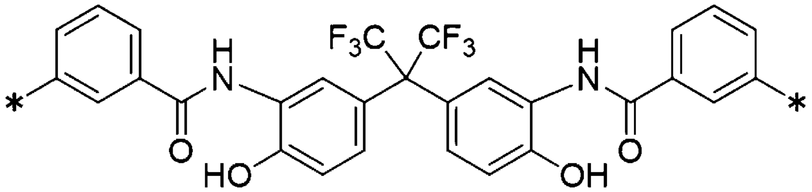

(8)

In Formulae (7) and (8), * represents a binding site bound to an amide structure.

The component (A-1) may contain a residue of a known diamine having no fluorine atom and/or a derivative thereof. Specific examples of the residue of a diamine having no fluorine atom and/or a derivative thereof include, but are not limited to, residues of: silicone diamines and cyclohexyldiamines, such as bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl) ether, bis(3-amino-4-hydroxy)biphenyl, bis(3-amino-4-hydroxyphenyl)fluorene, 3-sulfonic acid-4,4'-diaminodiphenyl ether, dimercaptophenylenediamine, 3,4'-diaminodiphenyl ether, 4,4'-diaminodiphenyl ether, 3,4'-diaminodiphenylmethane, 4,4'-diaminodiphenylmethane, 3,4'-diaminodiphenylsulfone, 4,4'-diaminodiphenylsulfone, 3,4'-diaminodiphenyl sulfide, 4,4'-diaminodiphenyl sulfide, 1,4-bis(4-aminophenoxy)benzene, benzine, m-phenylenediamine, p-phenylenediamine, 1,5-naphthalenediamine, 2,6-naphthalenediamine, bis(4-aminophenoxyphenyl)sulfone, bis(3-aminophenoxyphenyl) sulfone, bis(4-aminophenoxy)biphenyl, bis{4-(4-aminophenoxy)phenyl} ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, 2,4-diamino-1,3,5-triazine (guanamine), 2,4-diamino-6-methyl-1,3,5-triazine (acetoguanamine), 2,4-diamino-6-phenyl-1,3,5-triazine (benzoguanamine), 1,3-bis(3-aminopropyl)-1,1,3,3-tetramethyldisiloxane, 1,3-bis(*p*-aminophenyl)-1,1,3,3-tetramethyldisiloxane, 1,3-bis(p-aminophenethyl)-1,1,3,3-tetramethyldisiloxane, and 1,7-bis(p-aminophenyl)-1,1,3,3,5,5,7,7-octamethyltetrasiloxane; methylenebis(cyclohexylamine); and compounds in which amine moieties of these residues are isocyanated or trimethylsilylated. In the component (A-1), these residues may be contained singly, or in combination of two or more thereof.

Further, in Formula (4), $R_4$ and $R_5$ each preferably contain an ethylene-type unsaturated double bond-containing monovalent organic group represented by the following Formula (18) or (19). By introducing an ethylene-type unsaturated double bond into Formula (4), the sensitivity can be improved.

[Chem. 16]

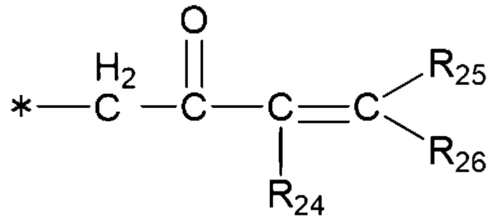

(18)

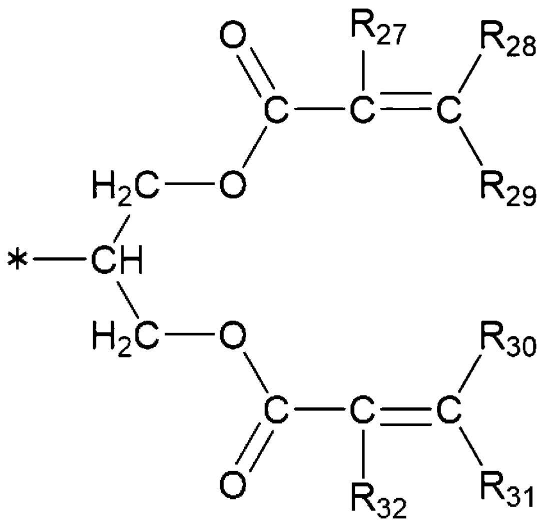

(19)

In Formula (18), $R_{24}$ represents a hydrogen atom or a methyl group; $R_{25}$ and $R_{26}$ each independently represent a hydrogen atom or an organic group having 1 to 3 carbon atoms; and * represents a binding site.

In Formula (19), $R_{27}$ and $R_{32}$ each represent a hydrogen atom or a methyl group; $R_{28}$ to $R_{31}$ each independently represent a hydrogen atom or an organic group having 1 to 3 carbon atoms; and * represents a binding site.

The content ratio of the repeating structural unit represented by Formula (4) in 100% by mole of all repeating structural units in the component (A-1) is preferably 50 to 100% by mole, more preferably 60 to 100% by mole, still more preferably 70 to 100% by mole. When the content ratio is 50 to 100% by mole, the heat resistance can be improved.

<Polybenzoxazole Precursor (A-2)>

Examples of the component (A-2) include products obtained by a reaction between a dicarboxylic acid, a corresponding dicarboxylic dichloride, a dicarboxylic acid active ester or the like, and a diamine such as a bisaminophenol compound, and the component (A-2) contains a dicarboxylic residue and/or a derivative residue thereof, and a bisaminophenol compound residue and/or a derivative residue thereof. Examples of the component (A-2) include polyhydroxyamides.

The component (A-2) is a thermosetting resin and, when heat-cured and dehydration-cyclized at a high temperature, forms a highly heat-resistant and rigid benzoxazole rings to yield a polybenzoxazole. Thus, by incorporating the component (A-2) into the negative photosensitive resin composition, the heat resistance of the resulting cured film can be greatly improved. Therefore, the component (A-2) is preferred when, for example, the cured film is to be used in an application where high heat resistance is required. Further, since the component (A-2) is a resin that improves in heat resistance after being dehydration-cyclized, the component (A-2) is suitable for, for example, the use in applications where the properties of a precursor structure before dehydrative cyclization and the heat resistance of a cured film are both desired to be achieved.

From the standpoint of improving the heat resistance and the i-line transmittance of a cured film, the component (A) preferably contains a repeating structural unit of the component (A-2) that is represented by the following Formula (5):

[Chem. 17]

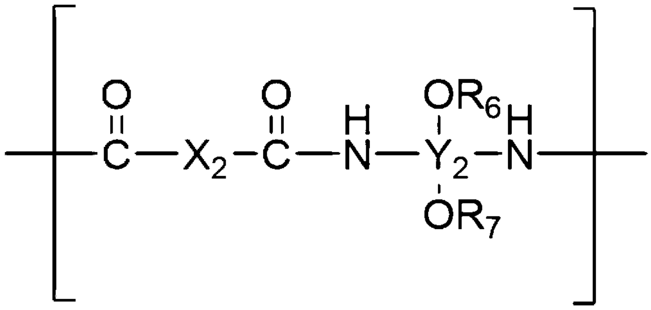

(5)

In Formula (5), $X_2$ represents a divalent organic group having an aliphatic structure having 2 to 20 carbon atoms, an alicyclic structure having 4 to 20 carbon atoms, or an aromatic structure having 4 to 40 carbon atoms; $Y_2$ represents a tetravalent organic group having an aliphatic structure having 2 to 20 carbon atoms, an alicyclic structure having 4 to 20 carbon atoms, or an aromatic structure having 4 to 40 carbon atoms; at least one of $X_2$ or $Y_2$ has a fluorine atom; and $R_6$ and $R_7$ each independently represent a hydrogen atom, a monovalent alkyl group having 1 to 20 carbon atoms, or an ethylene-type unsaturated double bond-containing monovalent organic group.

In Formula (5), $X_2$ represents a dicarboxylic acid residue and/or a derivative residue thereof, and $Y_2$ represents a bisaminophenol compound residue and/or a derivative residue thereof. Examples of the dicarboxylic acid derivative include dicarboxylic anhydrides, dicarboxylic acid chlorides, dicarboxylic acid active esters, tricarboxylic anhydrides, tricarboxylic acid chlorides, tricarboxylic acid active esters, and diformyl compounds.

Specific examples of a residue of a dicarboxylic acid or a derivative thereof include, but are not limited to, residues of terephthalic acid, isophthalic acid, diphenyl ether dicarboxylic acid, bis(carboxyphenyl)hexafluoropropane, biphenyldicarboxylic acid, benzophenone dicarboxylic acid, triphenyldicarboxylic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, and the like. In the component (A-2), these residues may be contained singly, or in combination of two or more thereof.

In the negative photosensitive resin composition, from the standpoint of improving the heat resistance and the i-line transmittance, $X_2$ in Formula (5) preferably contains a structure represented by the following Formula (11).

[Chem. 18]

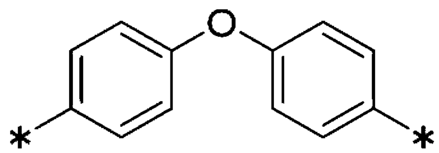

(11)

In Formula (11), * represents a binding site bound to an amide structure.

Specific examples of a residue of a bisaminophenol compound or a derivative thereof include, but are not limited to, residues of 2,2-bis(3-amino-4-hydroxyphenyl)hexafluoropropane, 2,2-bis[3-(3-aminobenzamide)-4-hydroxyphenyl] hexafluoropropane, bis(3-amino-4-hydroxyphenyl) ether, bis(3-amino-4-hydroxyphenyl)methylene, bis[*N*-(3-aminobenzoyl)-3-amino-4-hydroxyphenyl]sulfone, bis[*N*-(4-aminobenzoyl)-3-amino-4-hydroxyphenyl]sulfone, bis(3-amino-4-hydroxyphenyl)sulfone, bis(3-amino-4-hydroxyphenyl)propane, 2,2'-bis[*N*-(3-aminobenzoyl)-3-amino-4-hydroxyphenyl] propane, 2,2'-bis[*N*-(4-aminobenzoyl)-3-amino-4-hydroxyphenyl]propane, 9,9-bis(3-amino-4-hydroxyphenyl)fluorene, 9,9-bis[*N*-(3-aminobenzoyl)-3-amino-4-hydroxyphenyl]fluorene, 9,9-bis[*N*-(4-aminobenzoyl)-3-amino-4-hydroxyphenyl]fluorene, *N*,*N*-bis(3-aminobenzoyl)-2,5-diamino-1,4-dihydroxybenzene, *N*,*N*-bis(4-aminobenzoyl)-2,5-diamino-1,4-dihydroxybenzene, *N*,*N*'-bis(4-aminobenzoyl)-4,4'-diamino-3,3-dihydroxybiphenyl, *N*,*N*'-bis(3-aminobenzoyl)-3,3'-diamino-4,4-dihydroxybiphenyl, *N*,*N*'-bis(4-aminobenzoyl)-3,3'-diamino-4,4-dihydroxybiphenyl, 3,3'-diamino-4,4'-biphenol, bis(3-amino-4-hydroxyphenyl)methane, 1,1-bis(3-amino-4-hydroxyphenyl)ethane, 2,2-bis(3-amino-4-hydroxyphenyl)propane, 1,3-bis(4-amino-3-hydroxyphenoxy)benzene, and the like. In the component (A-2), these residues may be contained singly, or in combination of two or more thereof.

In the negative photosensitive resin composition, from the standpoint of improving the heat resistance and the i-line transmittance, it is preferred that $Y_2$ in Formula (5) contain a structure represented by the following Formula (21) or a structure represented by the following Formula (22), and that a total content [% by mole] of the structure represented by Formula (21) and the structure represented by Formula (22) be in a range of 70% by mole to 100% by mole in 100% by mole of all diamine residues of the polybenzoxazole precursor (A-2) having the repeating structural unit represented by Formula (5).

[Chem. 19]

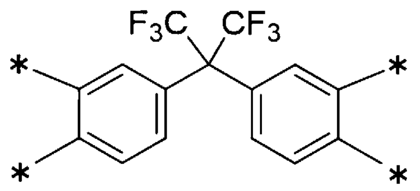

(21)

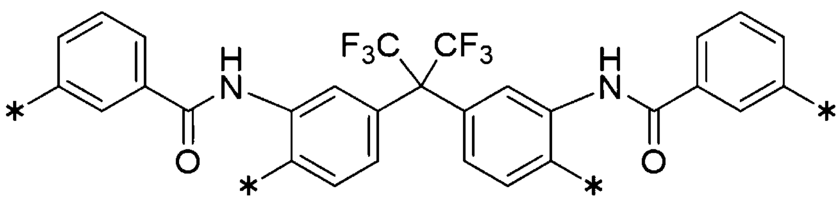

(22)

In Formulae (21) and (22), * represents a binding site bound to an amide structure or an oxygen atom.

Further, in Formula (5), $R_6$ and $R_7$ each preferably contain an ethylene-type unsaturated double bond represented by the following Formula (20). By introducing the ethylene-type unsaturated double bond into Formula (5), the sensitivity can be improved.

[Chem. 20]

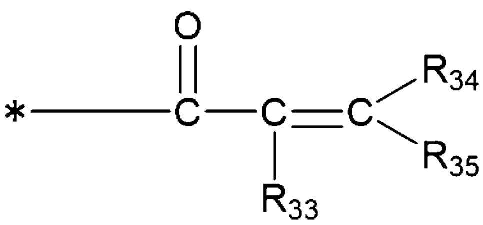

(20)

In Formula (20), $R_{33}$ represents a hydrogen atom or a methyl group; $R_{34}$ and $R_{35}$ each independently represent a hydrogen atom or an organic group having 1 to 3 carbon atoms; and * represents a binding site.

The component (A-2) preferably contains the repeating structural unit represented by Formula (5) as a main component, and the content ratio of the repeating structural unit represented by Formula (5) in all repeating structural units in the component (A-2) is preferably 50 to 100% by mole, more preferably 60 to 100% by mole, still more preferably 70 to 100% by mole. When the content ratio is 50 to 100% by mole, the resolution can be improved.

<Copolymer Thereof (A-3)>

The component (A-3) can be obtained, for example, as a random copolymer containing a polyimide repeating structural unit and a polybenzoxazole repeating structural unit by allowing the raw materials of the polyimide precursor (A-1) and the raw materials of the polybenzoxazole precursor (A-2) to react all at once, or as a block copolymer containing a repeating structural unit of a polyimide precursor and a repeating structural unit of a polybenzoxazole precursor by separately synthesizing the repeating structural unit of the polyimide precursor and the repeating structural unit of the polybenzoxazole precursor, and subsequently allowing these structural units to react with each other.

The component (A-3) preferably has, for example, both the repeating structural unit represented by Formula (4), which is a repeating structural unit of a polyimide precursor, and the repeating structural unit represented by Formula (5), which is a repeating structural unit of a polybenzoxazole precursor.

Further, similarly to the polyimide precursor (A-1), the component (A-3) preferably has the repeating structural unit represented by Formula (4). When the component (A) contains the component (A-3) and the component (A-3) has the repeating structural unit represented by Formula (4), the heat resistance of a cured article of the component (A-3) is improved, which is preferred.

In addition, similarly to the component (A-1), from the standpoint of increasing the i-line transmittance and improving the heat resistance of the cured article, it is preferred that the component (A-3) contain the repeating structural unit represented by Formula (4); that $Y_1$ in Formula (4) contain a structure represented by Formula (7) or a structure represented by Formula (8); and that a total content [% by mole] of the structure represented by Formula (7) and the structure represented by Formula (8) be in a range of 70% by mole to 100% by mole in 100% by mole of all diamine residues of the (A-1) polyimide precursor having the repeating structural unit represented by Formula (4).

<Structural Unit Derived from Diamine Having Silyl Group or Siloxane Bond, or Derivative Thereof>

One or more selected from the components (A-1), (A-2), and (A-3) preferably contain a structural unit derived from a diamine having a silyl group or a siloxane bond, and/or a structural unit derived from a derivative of the diamine. When one or more selected from the components (A-1), (A-2), and (A-3) contain a structural unit derived from a diamine having a silyl group or a siloxane bond, and/or a structural unit derived from a derivative of the diamine, the interaction between a cured film of the negative photosensitive resin composition and the substrate interface is increased, so that the adhesion with the substrate and the chemical resistance of the cured film can be improved.

<End-Capping Agent>

In one or more selected from the components (A-1), (A-2), and (A-3), the resin ends may be capped with an end-capping agent, such as a monoamine, a dicarboxylic anhydride, a monocarboxylic acid, a monocarboxylic chloride, or a monocarboxylic acid active ester.

By capping the resin ends with an end-capping agent, the storage stability of a coating liquid of the resin composition containing one or more selected from the components (A-1) and (A-2) can be improved.

Further, the resin ends are preferably capped with an end-capping agent having a thermally reactive group. Specific examples of the end-capping agent having a thermally reactive group include, but are not limited to, 4-ethynylaniline, 4-aminostyrene, 5-norbornene-2,3-dicarboxylic acid, maleic anhydride, and 4-phenylethynylphthalic anhydride. By capping the resin ends with such an end-capping agent having a thermally reactive group, the chemical resistance and the elongation of the cured film after heat treatment can be improved.

<Method for Producing Alkali-Soluble Resin (A)>

The component (A) according to the present invention is synthesized by a known method.

Examples of a method for producing a polyamic acid that is one example of the component (A-1) include a method of allowing a tetracarboxylic dianhydride and a diamine compound to react in a solvent at a low temperature.

Examples of a method for producing a polyamic acid ester that is another example of the component (A-1) include, in addition to a method of allowing the above-described polyamic acid to react with an esterification agent: a method of obtaining a diester from a tetracarboxylic dianhydride and an alcohol, and subsequently allowing the diester to react with an amine in a solvent in the presence of a condensing agent; and a method of obtaining a diester from a tetracarboxylic dianhydride and an alcohol, subsequently forming an acid chloride from the remaining dicarboxylic acid, and then allowing the resultants to react with an amine in a solvent. From the standpoint of the ease of synthesis, the method preferably includes the step of allowing a polyamic acid to react with an esterification agent. The esterification agent is not particularly limited, and any known method can be applied; however, from the standpoint of the ease of purification of the resulting resin, the esterification agent is preferably N,N-dimethylformamide dialkyl acetal.

Examples of a method for producing a polyhydroxyamide that is one example of the component (A-2) include a method of allowing a bisaminophenol compound and a dicarboxylic acid to undergo a condensation reaction in a solvent. Specific examples thereof include: a method of allowing a dehydration condensing agent such as dicyclohexylcarbodiimide (DCC) to react with an acid, and adding a bisaminophenol compound to the resultant; and a method of adding dropwise a solution of a dicarboxylic acid dichloride to a solution of a bisaminophenol compound to which a tertiary amine such as pyridine has been added.

As for a method for producing the component (A-3), the component (A-3) can be synthesized by, for example, a combination of the above-described method for producing the polyimide precursor (A-1) and the above-described method

for producing the polybenzoxazole precursor (A-2).

<Physical Properties of Polyimide Precursor (A-1), Polybenzoxazole Precursor (A-2), and Copolymer Thereof (A-3)>

One or more from the components (A-1), (A-2), and (A-3) have a weight-average molecular weight (hereinafter, abbreviated as "Mw") of preferably 1,000 or more, more preferably 3,000 or more, still more preferably 5,000 or more, in terms of polystyrene as measured by gel permeation chromatography (hereinafter, abbreviated as "GPC"). When the Mw is 1,000 or more, the post-development resolution can be improved. Meanwhile, the Mw is preferably 500,000 or less, more preferably 300,000 or less, still more preferably 100,000 or less. When the Mw is 500,000 or less, the leveling property in coating and the pattern processability with an alkaline developer can be improved.
Further, the number-average molecular weight (hereinafter, abbreviated as "Mn") is preferably 1,000 or more, more preferably 3,000 or more, still more preferably 5,000 or more, in terms of polystyrene as measured by GPC. When the Mn is 1,000 or more, the post-development resolution can be improved.
Meanwhile, the Mn is preferably 500,000 or less, more preferably 300,000 or less, still more preferably 100,000 or less. When the Mn is 500,000 or less, the leveling property in coating and the pattern processability with an alkaline developer can be improved.
The Mw and the Mn of the components (A-1), (A-2), and (A-3) are measured by GPC as polystyrene-equivalent values. The number n of repeating structural units in the respective components (A-1), (A-2), and (A-3) can be calculated by n = Mw/M, wherein M is the molecular weight of a structural unit, and Mw is the weight-average molecular weight of a resin.
In the present invention, the content ratio of structural units derived from various carboxylic acid residues, diamine residues, monoamine residues, and derivatives thereof in the component (A-1), the component (A-2), and/or the component (A-3) is determined by the following method.
When the monomer feed ratio at the time of the polymerization of the component (A-1), the component (A-2), and/or the component (A-3) is known, the content ratio is calculated from the monomer feed ratio.
Meanwhile, when the monomer feed ratio at the time of the polymerization of the component (A-1), the component (A-2), and/or the component (A-3) is unknown, the negative photosensitive resin composition or the component (A-1), the component (A-2), and/or the component (A-3) are directly analyzed by $^1$H-NMR.
For more reliable identification and qualitative and quantitative analysis of copolymerized components, the component (A-1), the component (A-2), and/or the component (A-3) are hydrolyzed with an alkali, and monomer components after decomposition are separated by a HPLC method. The substituent information of each of the thus obtained fragments is analyzed by FT-IR, and the structural information is identified by $^1$H-NMR and $^{13}$C-NMR. If such identification is difficult, a GC/MS analysis is further performed, and the copolymerized components are identified by combining the mass information.

<Photopolymerization Initiator Having Photobleaching Property (B)>

The negative photosensitive resin composition of the present invention further contains a component (B).
The term "photopolymerization initiator" used herein refers to a compound that generates radicals through bond cleavage and/or reaction when exposed to light. A compound having a structural unit that generates radicals through bond cleavage and/or reaction when exposed to light is herein defined as a photopolymerization initiator. By incorporating a photopolymerization initiator, radical polymerization of the below-described component (C) proceeds, and exposed parts of a film of the resin composition are insolubilized in an alkaline developer, whereby a negative pattern can be formed. In addition, UV curing during exposure is facilitated, so that the sensitivity can be improved.
Further, by incorporating a specific amount or more of a photopolymerization initiator, a change in pattern opening width before and after heat curing can be inhibited. This is believed to be attributable to an increase in the amount of radicals generated from the photopolymerization initiator during exposure. In other words, it is presumed that, by increasing the amount of radicals generated during exposure, the collision probability between the generated radicals and the ethylene-type unsaturated double bond group in the below-described component (C) is increased, and this facilitates UV curing and improves the crosslink density, as a result of which the reflow of pattern taper and pattern foot during heat curing is suppressed, and a change in pattern opening width before and after heat curing can thereby be inhibited.
The "photobleaching property" refers to a property that, as a result of bond cleavage and/or reaction caused by UV light during exposure, the absorbance decreases in the ultraviolet wavelength range (shorter than 380 nm) and/or a part or the entirety of the visible light wavelength range (380 nm to 780 nm). The photobleaching property improves the transparency upon light irradiation, allowing a light to penetrate to the inside, so that a rectangular pattern can be formed without the occurrence of undercutting during pattern processing even in the form of a thick film.
Examples of the photopolymerization initiator having a photobleaching property include acylphosphine oxide-based photopolymerization initiators, fluorene-type oxime initiators, diphenyl sulfide-type oxime initiators, and oxime

initiators in which an oxime ester group is bound to carbazole or the like via a carbonyl group.

The photobleaching property is examined by the following method. First, the photopolymerization initiator is dissolved in a soluble solvent, and the absorbance is measured using a spectrophotometer. In this process, the concentration of the resulting solution is adjusted to be in the measurement range of the spectrophotometer. As the solvent, one that does not interfere with the measurement of the absorbance of the photopolymerization initiator, such as methanol, ethanol, chloroform, acetonitrile, propylene glycol monomethyl ether acetate, or ethyl lactate, is used. Next, the solution of the photopolymerization initiator is sufficiently exposed to light having a wavelength at which the photopolymerization initiator absorbs light and reacts, and the absorbance is measured again. The pre-exposure absorbance Abs (before exposure) at which, when the absorbance at a maximum absorption wavelength before the exposure is taken as 100%, the absorbance is 20% in a longer wavelength region than the maximum absorption wavelength, is determined. If there are two or more maximum absorption wavelengths, the maximum absorption wavelength in a longer wavelength region is used. Thereafter, the post-exposure absorbance Abs (after exposure) at the same wavelength as that of the Abs (before exposure) is determined, and the Abs (before exposure) and the Abs (after exposure) are compared. A relationship of Abs (before exposure) > Abs (after exposure) indicates that the photopolymerization initiator has a photobleaching property.

Examples of the component (B) include IRGACURE 819 (manufactured by BASF Ltd.), NCI-930 (trade name, manufactured by ADEKA Corporation), NCI-730 (trade name, manufactured by ADEKA Corporation), OXE-01 (trade name, manufactured by BASF Ltd.), OXE-04 (trade name, manufactured by BASF Ltd.), PBG-305 (trade name, manufactured by Changzhou Tronly New Electronic Materials Co., Ltd.), PBG-3057 (trade name, manufactured by Changzhou Tronly New Electronic Materials Co., Ltd.), PBG-345 (trade name, manufactured by Changzhou Tronly New Electronic Materials Co., Ltd.), and PBG-358 (trade name, manufactured by Changzhou Tronly New Electronic Materials Co., Ltd.).

From the standpoint of the transparency of a coating film before and after UV irradiation, the component (B) preferably has a structure represented by the following Formula (1). When the component (B) has a structure represented by the following Formula (1), the transmittance of i-line (wavelength: 365 nm) does not decrease during photopolymerization, so that the occurrence of undercutting can be inhibited even in thick film processing.

[Chem. 21]

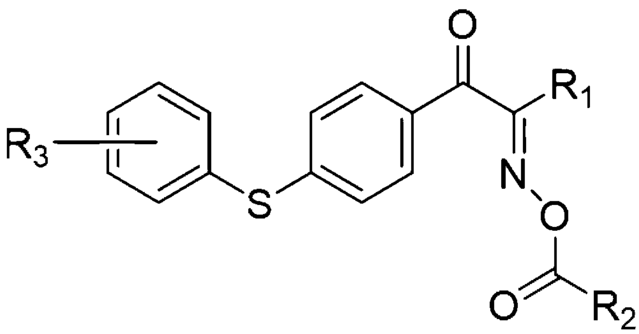

(1)

In Formula (1), $R_1$ and $R_2$ each independently represent an alkyl group having 1 to 12 carbon atoms, a cycloalkyl group having 4 to 10 carbon atoms, a phenyl group, or a tolyl group; and $R_3$ represents an alkyl group having 0 to 5 carbon atoms, -OH, -COOH, $-O(CH_2)OH$, $-O(CH_2)_2OH$, $-COO(CH_2)OH$, or - $COO(CH_2)_2OH$.

Examples of the component (B) having the structure represented by Formula (1) include NCI-930 (trade name, manufactured by ADEKA Corporation) and some of the compounds described in WO 2015/036910.

The content of the component (B) in the negative photosensitive resin composition of the present invention is preferably 0.1 parts by mass or more, more preferably 0.5 parts by mass or more, still more preferably 0.7 parts by mass or more, particularly preferably 1 part by mass or more, when a total amount of the components (A) and (C) is assumed to be 100 parts by mass. When the content is 0.1 parts by mass or more, the sensitivity during exposure can be improved. Further, from the standpoint of controlling the pattern opening width, the content of the component (B) is preferably 10 parts by mass or more, more preferably 12 parts by mass or more, still more preferably 14 parts by mass or more, particularly preferably 15 parts by mass or more. When the content is 10 parts by mass or more, a change in pattern opening width before and after heat curing can be inhibited. Meanwhile, the content of the component (B) is preferably 30 parts by mass or less, more preferably 25 parts by mass or less, still more preferably 22 parts by mass or less, particularly preferably 20 parts by mass or less. When the content is 30 parts by mass or less, undercutting can be inhibited even in thick film processing, without causing a decrease in the transmittance of i-line (wavelength: 365 nm) during photopolymerization.

<Polymerizable Compound (C)>

The negative photosensitive resin composition of the present invention further contains a component (C). The component (C) refers to a compound having plural ethylene-type unsaturated double bond groups in the molecule. During exposure, radicals generated from the above-described component (B) cause the radical polymerization of the component (C) to proceed, and exposed parts of a film of the resin composition are insolubilized in an alkaline developer, whereby a negative pattern can be formed.

By incorporating the component (C), UV curing during exposure is facilitated, so that the sensitivity during exposure can be improved. In addition, the crosslink density after heat curing is increased, so that the hardness of the resulting cured film can be improved.

As the component (C), a compound having a (meth)acryl group, which easily undergoes radical polymerization, is preferred. From the standpoint of improving the sensitivity during exposure and the hardness of the resulting cured film, a compound having two or more (meth)acryl groups in the molecule is more preferred. From the standpoint of improving the sensitivity during exposure, the double-bond equivalent of the component (C) is preferably 80 to 800 g/mol.

Examples of the component (C) include: the below-described (C-1) polyethylene glycol dimethacrylate represented by Formula (2), (C-2) polyethylene glycol dimethacrylate represented by the following Formula (3), and (C-3) polymerizable compound having a blocked isocyanate structure; and other compounds, such as trimethylolpropane di(meth)acrylate, trimethylolpropane tri(meth)acrylate, ditrimethylolpropane tri(meth)acrylate, ditrimethylolpropane tetra(meth)acrylate, 1,3-butanediol di(meth)acrylate, neopentyl glycol di(meth)acrylate, 1,4-butanediol di(meth)acrylate, 1,6-hexanediol di(meth)acrylate, 1,9-nonanediol di(meth)acrylate, 1,10-decanediol di(meth)acrylate, dimethylol-tricyclodecane di(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol hepta(meth)acrylate, tripentaerythritol octa(meth)acrylate, tetrapentaerythritol nona(meth)acrylate, tetrapentaerythritol deca(meth)acrylate, pentapentaerythritol undeca(meth)acrylate, pentapentaerythritol dodeca(meth)acrylate, ethoxylated bisphenol A di(meth)acrylate, 2,2-bis[4-(3-(meth)acryloxy-2-hydroxypropoxy)phenyl]propane, 1,3,5-tris((meth)acryloxyethyl)isocyanuric acid, 1,3-bis((meth)acryloxyethyl)isocyanuric acid, and acid-modified products thereof.

From the standpoint of the miscibility with the component (A), it is preferred to use a (meth)acrylate containing a structure represented by the following Formula (16).

[Chem. 22]

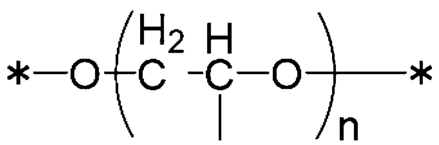

(16)

In Formula (16), * represents a binding site, and n represents an integer of 1 to 12.

From the standpoint of preventing elution of the exposed parts during development and further reducing the decrease in film thickness after development, it is preferred to use a polymerizable compound represented by the following Formula (17).

[Chem. 23]

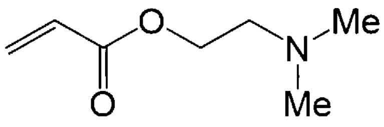
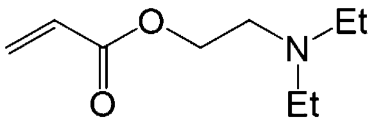

(17)

In Formula (17), Me represents a methyl group, and Et represents an ethyl group.

The content of the component (C) in the negative photosensitive resin composition of the present invention is preferably 15% by mass or more, more preferably 20% by mass or more, still more preferably 25% by mass or more, particularly preferably 30% by mass or more, when a total amount of the components (A) and (C) is assumed to be 100% by mass. When the content is 15% by mass or more, not only the sensitivity during exposure can be improved, but also a cured film having a low-taper pattern shape can be obtained. Meanwhile, the content of the component (C) is preferably 65% by mass or less, more preferably 60% by mass or less, still more preferably 55% by mass or less, particularly preferably 50% by mass or less. When the content is 65% by mass or less, not only the pattern opening width can be controlled, but also the heat resistance of the cured film can be improved.

From the standpoint of improving the heat resistance of the cured film, it is preferred that, when a polymer of the component (C) is heated from room temperature to 380°C at a heating rate of 10°C/min in a nitrogen atmosphere using a thermogravimetric analyzer, a residual rate after 1-hour heat treatment at 380°C be 10% by mass or less. By heat-treating and thereby decomposing and volatilizing the polymer of the component (C) used for patterning, the concentration of the component (A) in the cured film is increased, so that the heat resistance of the cured film can be improved.

Examples of the component (C) that is preferred because of a low residual rate of its polymer after heat treatment include polyethylene glycol (meth)acrylate, alkoxy polyethylene glycol (meth)acrylate, polyethylene glycol di(meth) acrylate, polypropylene glycol di(meth)acrylate, alkyl (meth)acrylate, and alkyl di(meth)acrylate.

<Polyethylene Glycol Dimethacrylate (C-1) Represented by Formula (2) and Polyethylene Glycol Dimethacrylate (C-2) Represented by Formula (3)>

The negative photosensitive resin composition of the present invention preferably further contains (C-1) a polyethylene glycol dimethacrylate represented by the following Formula (2) (hereinafter, may be referred to as "component (C-1)") and (C-2) a polyethylene glycol dimethacrylate represented by the following Formula (3) (hereinafter, may be referred to as "component (C-2)"), and the component (C) preferably contains 4 to 20 parts by mass of the component (C-2) with respect to 100 parts by mass of the component (C-1). This enables the processing of a pattern shape into a rectangle with a low exposure dose even in thick film processing, without deterioration of the miscibility with the component (A).

[Chem. 24]

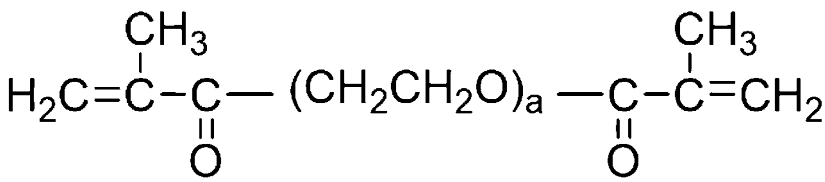

(2)

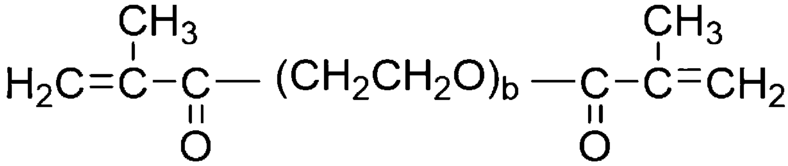

(3)

In Formula (2), a represents an integer of 4 to 9. In Formula (3), b represents an integer of 1 to 3.

Examples of a compound represented by Formula (2) in which a is an integer of 4 to 9 include polyethylene glycol #200 dimethacrylate and polyethylene glycol #400 dimethacrylate.

From the standpoint of the miscibility with the component (A), polyethylene glycol #200 dimethacrylate is preferred.

Examples of a compound represented by Formula (3) in which b is an integer of 1 to 3 include monoethylene glycol dimethacrylate, diethylene glycol dimethacrylate, and triethylene glycol dimethacrylate.

From the standpoint of improving the sensitivity, monoethylene glycol dimethacrylate is preferred.

The negative photosensitive resin composition of the present invention preferably further contains (C-4) a polyethylene glycol dimethacrylate represented by the following Formula (23) (hereinafter, may be referred to as "component (C-4)") and the component (C-2), and the content of the component (C-2) is preferably 15 to 50 parts by mass with respect to 100 parts by mass of the component (C-4). In this range, a pattern shape can be processed into a rectangle with a low exposure dose in thick film processing, and a polymer of the component (C-4) is decomposed and volatilized during heat treatment, so that the heat resistance of the cured film can be improved.

[Chem. 25]

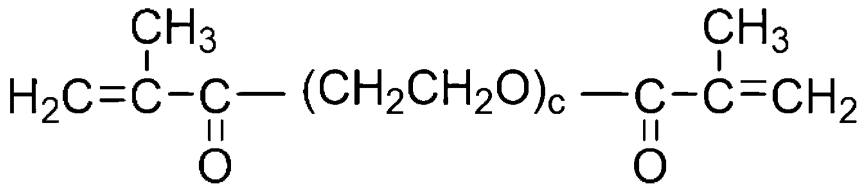

(23)

(In Formula (23), c represents an integer of 9 to 14)

Examples of a compound represented by Formula (23) in which c is an integer of 9 to 14 include polyethylene glycol #400 dimethacrylate and polyethylene glycol #600 dimethacrylate.

From the standpoint of improving the heat resistance of the cured film, polyethylene glycol #400 dimethacrylate and polyethylene glycol #600 dimethacrylate are preferred.

<Polymerizable Compound Having Blocked Isocyanate Structure (C-3)>

The component (C) preferably contains (C-3) a polymerizable compound having a blocked isocyanate structure (hereinafter, may be referred to as "component (C-3)"), and
the content of the component (C-3) is preferably 0.5 to 15 parts by mass with respect to 100 parts by mass of the component (A).

The component (C-3) can be obtained by allowing a compound having an isocyanate group and an unsaturated bond in the molecule to react with a compound containing an active hydrogen group (blocking agent).

The unsaturated bond refers to a group capable of undergoing chain polymerization in the presence of an active species such as a radical or a cation. Examples of the unsaturated bond include unsaturated double bonds of a vinyl group, an allyl group, an acryloyl group, a methacryloyl group and the like, and unsaturated triple bonds of a propargyl group and the like, among which conjugated-type vinyl group, acryloyl group, and methacryloyl group are preferred in terms of polymerizability.

The compound having an isocyanate group and an unsaturated bond in the molecule is not particularly limited; however, it preferably has, for example, a structure represented by the following Formula (12) or (13). By allowing such a polymerizable compound having a blocked isocyanate structure and an unsaturated bond to react with a compound containing an active hydrogen group (blocking agent), a compound represented by Formula (12) or (13) can be obtained.

[Chem. 26]

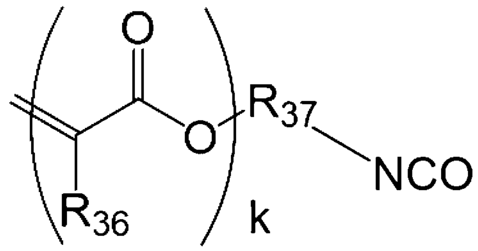

(12)

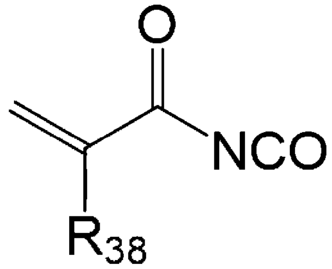

(13)

In Formulae (12) and (13), $R_{36}$ and $R_{38}$ each independently represent a hydrogen atom or a methyl group. $R_{37}$ represents a hydrocarbon group having 1 to 20 carbon atoms, and the hydrogen atoms of the hydrocarbon group are each optionally substituted with a group having at least one atom selected from the group consisting of N, O, F, S, and P. $R_{37}$ is preferably a methylene group, an ethylene group, a propylene group, a phenylene group, or a group in which some of the hydrogen atoms of these groups are substituted with a methyl group or an ethyl group. Further, k represents an integer of 1 to 3. From the standpoint of the reactivity with a compound containing an active hydrogen group (blocking agent), k is particularly preferably 1.

Specific examples of the compound represented by Formula (12) include 2-isocyanatoethyl acrylate, 2-isocyanatoethyl methacrylate, 3-isocyanatopropyl acrylate, 3-isocyanatopropyl methacrylate, 2-isocyanato-1-methylethyl acrylate, 2-isocyanato-1-methylethyl methacrylate, 3-acryloyloxyphenyl isocyanate, 3-methacryloyloxyphenyl isocyanate, 3-isocyanato-2-methylbutyl acrylate, 3-isocyanato-2-methylbutyl methacrylate, 4-acryloyloxyphenyl isocyanate, 4-methacryloyloxyphenyl isocyanate, 3-acryloyloxyphenyl isocyanate, 3-methacryloyloxyphenyl isocyanate, 2-acryloyloxyphenyl isocyanate, 2-methacryloyloxyphenyl isocyanate, 3,5-bis(methacryloyloxyethyl)phenyl isocyanate, 2,4-bis(acryloyloxy)phenyl isocyanate, 1,1-bis(acryloyloxymethyl)ethyl isocyanate, and 1,1-bis(methacryloyloxymethyl)ethyl isocyanate. Specific examples of the compound represented by Formula (13) include acryloyl isocyanate and methacryloyl isocyanate.

The blocking agent is not particularly limited as long as it is an active hydrogen-containing compound, and examples thereof include thiols, phenols, oximes, amines, imines, carbazoles, amides, imides, ureas, alkyl acetoacetates, alkyl malonates, pyrazoles, imidazoles, and triazoles. These blocking agents have a low dissociation temperature of about 200°C or lower; therefore, they are more effectively dissociated by a low-temperature heat treatment (curing), and the chemical resistance is thus further improved, which is preferred.

Specific examples of preferred blocking agents include: thiols, such as methanethiol, ethanethiol, and benzenethiol; phenols, such as phenol, o-nitrophenol, *m*-nitrophenol, *p*-nitrophenol, cresol, 1-naphthol, and 2-naphthol; oximes, such as acetone oxime, methyl ethyl ketoxime, methyl isobutyl ketoxime, and cyclohexanone oxime; amines, such as dibutylamine, diphenylamine, and aniline; imines, such as ethyleneimine and propyleneimine; carbazoles, such as unsubstituted carbazole, 1,3,6,8-tetranitrocarbazole, and 3,6-dibromocarbazole; amides, such as acetanilide, acetic acid amide, $\varepsilon$-caprolactam, and $\gamma$-butyrolactam; imides, such as succinimide, *N*-hydroxysuccinimide, and maleimide; ureas, such as urea, ethylene urea, and thiourea; acetoacetic acid alkyl esters, such as ethyl acetoacetate; malonic acid alkyl esters, such as diethyl malonate; pyrazoles, such as unsubstituted pyrazole, 3,5-dimethylpyrazole, 3-acetylaminopyrazole, and pyrazole-3,5-dicarboxylic acid diethyl ester; imidazoles, such as unsubstituted imidazole, 2-methylimidazole, 2-ethylimidazole, and 2-phenylimidazole; and triazoles, such as 1,2,3-triazole, 1,2,4-triazole, and benzotriazole.

By allowing a compound having an isocyanate group and a polymerizable unsaturated functional group in the molecule, which compound is represented by Formula (12) or (13), to react with a compound containing an active hydrogen group (blocking agent), a compound represented by the following Formula (14) or (15) can be obtained.

[Chem. 27]

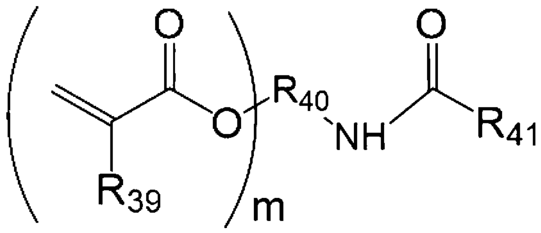

(14)

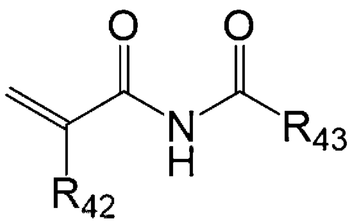

(15)

In Formulae (14) and (15), $R_{39}$ and $R_{42}$ each independently represent a hydrogen atom or a methyl group. $R_{40}$ represents a hydrocarbon group having 1 to 20 carbon atoms, and the hydrogen atoms of the hydrocarbon group are each optionally substituted with a group having at least one atom selected from the group consisting of N, O, F, S, and P. $R_{41}$ and $R_{43}$ each represent an active hydrogen compound residue, excluding alcohols. Further, m represents an integer of 1 to 3. From the standpoint of reducing the steric hindrance and further improving the reactivity of the isocyanate group during a heat treatment (curing), m is preferably 1.

The component (C-3) is used singly, or in combination of two or more thereof. The component (C-3) preferably contains a compound represented by Formula (14) and/or a compound represented by Formula (15).

The content of the component (C-3) is preferably 0.5 parts by mass to 15 parts by mass with respect to a total amount of 100 parts by mass of the component (A). By controlling the content of the component (C-3) to be 0.5 parts by mass or more, elution of exposed parts during development can be prevented, so that a resin composition that exhibits a smaller decrease in film thickness after development and excellent post-curing chemical resistance can be obtained. By controlling the content of the component (C-3) to be 15 parts by mass or less, film clouding during film formation can be inhibited.

<Sensitizer (D)>

The negative photosensitive resin composition of the present invention further contains a sensitizer. The sensitizer refers to a compound capable of absorbing the energy from exposure to generate excited triplet electrons by internal conversion and intersystem crossing and thereby mediate energy transfer to the above-described component (B) and the like.

By incorporating the component (D), not only the sensitivity during exposure is improved but also undercutting is inhibited, so that a rectangular pattern can be obtained. This is presumably because the sensitizer absorbs a long-wavelength light that is not absorbed by the component (B) and the like, and the energy thereof is transferred from the sensitizer to the component (B) and the like, whereby the photoreaction efficiency can be improved.

The component (D) contains (D-1) a thioxanthone-based sensitizer (hereinafter, may be referred to as "component (D-1)"), and the content of the component (D-1) is preferably 5 to 30 parts by mass with respect to 100 parts by mass of the component (B). In this range, not only the sensitivity during exposure is improved but also undercutting is inhibited, so that a rectangular pattern can be obtained.

Examples of the component (D-1) include thioxanthone, 2-methylthioxanthone, 2-ethylthioxanthone, 2-propylthioxanthone, 4-methylthioxanthone, 4-ethylthioxanthone, 4-propylthioxanthone, 2-methyl-4-ethylthioxanthone, 2-ethyl-4-propylthioxanthone, 2-ethyl-4-methylthioxanthone, 2-ethyl-4-propylthioxanthone, 2-propyl-4-methylthioxanthone, 2-propyl-4-ethylthioxanthone, 2,4-dimethylthioxanthone, 2,4-diethylthioxanthone, 2,4-dipropylthioxanthone, and 2,4-dichlorothioxanthone.

The content of the component (D) in the negative photosensitive resin composition of the present invention is preferably 0.01 parts by mass or more, more preferably 0.1 parts by mass or more, still more preferably 0.5 parts by mass or more, particularly preferably 1 part by mass or more, when a total amount of the components (A) and (C) is assumed to be 100 parts by mass. When the content is 0.01 parts by mass or more, the sensitivity during exposure can be improved.

Meanwhile, the content of the sensitizer is preferably 15 parts by mass or less, more preferably 13 parts by mass or less, still more preferably 10 parts by mass or less, particularly preferably 8 parts by mass or less. When the content is 15 parts by mass or less, undercutting is inhibited, enabling the processing of a pattern shape into a rectangle.

The content of the component (D-1) in the negative photosensitive resin composition of the present invention is preferably 0.01 parts by mass or more, more preferably 0.1 parts by mass or more, still more preferably 0.5 parts by mass or more, particularly preferably 1 part by mass or more, when a total amount of the components (A) and (C) is assumed to be 100 parts by mass. When the content is 0.01 parts by mass or more, the sensitivity during exposure can be improved. Meanwhile, the content of the sensitizer is preferably 15 parts by mass or less, more preferably 13 parts by mass or less, still more preferably 10 parts by mass or less, particularly preferably 8 parts by mass or less. When the content is 15 parts by mass or less, undercutting is inhibited, enabling the processing of a pattern shape into a rectangle.

<Specific Compound>

From the standpoint of further enhancing the effect of improving the developer adhesion, the negative photosensitive resin composition of the present invention preferably contains a compound represented by the following Formula (6).

[Chem. 28]

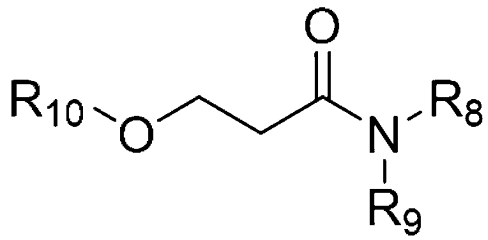

(6)

In Formula (6), $R_8$, $R_9$, and $R_{10}$ each independently represent an alkyl group having 1 to 6 carbon atoms.

From the standpoint of the miscibility with the component (A), β-alkoxypropionamide, which is a compound represented by Formula (6), is preferably 3-methoxy-*N,N*-dimethylpropionamide or 3-butoxy-N,N-dimethylpropionamide.

In the present invention, from the standpoint of improving the developer adhesion, the content of *β*-alkoxypropionamide is preferably 0.1 parts by mass or more, more preferably 1 part by mass or more, with respect to 100 parts by mass of the component (A). Meanwhile, from the standpoint of enabling the formation of a desired patterned film as a developed film, the content of *β*-alkoxypropionamide is preferably 15 parts by mass or less, more preferably 7 parts by mass or less.

<Additives>

The negative photosensitive resin composition of the present invention, if necessary, may further contain additives, such as a polymerization inhibitor, a crosslinking agent, a silane coupling agent, and a surfactant.

The polymerization inhibitor is preferably a phenolic polymerization inhibitor. Examples of the phenolic polymerization inhibitor include "IRGANOX" (registered trademark) 245, 259, 565, 1010, 1035, 1076, 1098, 1135, 1330, 1425, 1520, 1726, and 3114 (all of which are manufactured by BASF Ltd.).

By incorporating a polymerization inhibitor, the generation of residues after development is inhibited, so that the post-development resolution can be improved.

The crosslinking agent is preferably a compound having two or more thermally crosslinkable groups, such as alkoxymethyl groups, methylol groups, epoxy groups, or oxetanyl groups, in the molecule.

Examples of a compound having two or more alkoxymethyl groups or methylol groups in the molecule include DML-PC, DML-OC, DML-PTBP, DML-PCHP, DML-MBPC, DML-MTrisPC, DMOM-PC, DMOM-PTBP, TriML-P, TriML-35XL, TML-HQ, TML-BPA, TML-BPAF, TMLBPAP, TMOM-BPA, TMOM-BPAF, TMOM-BPAP, HML-TPHAP, and HMOM-TPHAP (all of which are manufactured by Honshu Chemical Industry Co., Ltd.), and "NIKALAC" (registered trademark) MX-290, MX-280, MX-270, MX-279, MW-100LM, MW-30HM, MW-390, and MX-750LM (all of which are manufactured by Sanwa Chemical Co., Ltd.). By incorporating a crosslinking agent, the heat resistance and the chemical resistance of the resulting cured film can be improved.

The silane coupling agent is preferably a trifunctional organosilane, tetrafunctional organosilane, or a silicate compound.

Examples of the trifunctional organosilane include vinyltrimethoxysilane, 3-acryloxypropyltrimethoxysilane, 4-styryltrimethoxysilane, 3-glycidoxypropyltrimethoxysilane, 3-trimethoxysilylpropylsuccinic anhydride, 3-aminopropyltrimethoxysilane, 3-(4-aminophenyl)propyltrimethoxysilane, 1-(3-trimethoxysilylpropyl)urea, 3-triethoxysilyl-N-(1,3-dimethylbutylidene)propylamine, 3-mercaptopropyltrimethoxysilane, 3-isocyanatepropyltriethoxysilane, 1,3,5-tris(3-trimethoxysilylpropyl)isocyanuric acid, X-12-989MS (manufactured by Shin-Etsu Chemical Co., Ltd.), and *N*-*t*-butyl-2-(3-trimethoxysilylpropyl)succinimide.

By incorporating a silane coupling agent, the interaction between a cured film of the resin composition and the substrate interface is increased, so that the adhesion with the substrate and the chemical resistance of the cured film can be improved.

The surfactant is preferably a fluororesin-based surfactant, a silicone-based surfactant, a polyoxyalkylene ether-based surfactant, or an acrylic resin-based surfactant.

By incorporating a surfactant in an appropriate amount, the surface tension of the resin composition can be adjusted as desired, so that the leveling property in coating can be improved, and the film thickness uniformity of a coating film can thus be improved.

<Solvent>

The photosensitive resin composition of the present invention may also contain a solvent. Examples of the solvent include: polar aprotic solvents, such as N-methyl-2-pyrrolidone, $\gamma$-butyrolactone, $\gamma$-valerolactone, $\delta$-valerolactone, *N,N*-dimethylformamide, *N,N*-dimethylacetamide, dimethyl sulfoxide, 1,3-dimethyl-2-imidazolidinone, *N,N*-dimethylpropylene urea, *N,N*-dimethylisobutyric acid amide, and methoxy-*N,N*-dimethylpropionamide; ethers, such as tetrahydrofuran, dioxane, propylene glycol monomethyl ether, and propylene glycol monoethyl ether; ketones, such as acetone, methyl ethyl ketone, and diisobutyl ketone; esters, such as ethyl acetate, butyl acetate, isobutyl acetate, propyl acetate, propylene glycol monomethyl ether acetate, and 3-methyl-3-methoxybutyl acetate; alcohols, such as ethyl lactate, methyl lactate, diacetone alcohol, and 3-methyl-3-methoxybutanol; and aromatic hydrocarbons, such as toluene and xylene. The photosensitive resin composition of the present invention may contain two or more of these solvents.

The content ratio of the solvent in the negative photosensitive resin composition of the present invention can be adjusted as appropriate in accordance with an application method and the like. For example, in the case of forming a coating film by spin coating, the content ratio of the solvent is generally 50 to 95% by mass of the entire negative photosensitive resin composition.

Next, the shape of the photosensitive resin composition of the present invention will be described.

The negative photosensitive resin composition of the present invention is not limited in terms of its shape as long as it contains the above-described components (A), (B), (C), and (D), and it may be in the form of, for example, a paste or a sheet. A photosensitive sheet of the present invention refers to a sheet-like material obtained by applying the photosensitive resin composition of the present invention onto a support and then drying the composition in such ranges of temperature and time that allow volatilization of the solvent, and the sheet-like material is not completely cured and is soluble in an organic solvent or an alkaline aqueous solution.

The support is not particularly limited, and various commercially available films, such as a polyethylene terephthalate (PET) film, a polyphenylene sulfide film, and a polyimide film, can be used. For the purpose of improving the adhesion and the peelability, the bonding surface of the support and the photosensitive resin composition may be surface-treated with silicone, a silane coupling agent, an aluminum chelating agent, polyurea, or the like. The thickness of the support is also not particularly limited; however, from the standpoint of workability, it is preferably in a range of 10 to 100 $\mu$m. Further, for the purpose of protecting the film surface of the photosensitive composition that is obtained by coating, a protective film may be provided on the film surface. By this, the surface of the photosensitive resin composition can be protected from contaminants, such as dust and dirt in the air.

Examples of a method for applying the photosensitive resin composition to a support include rotary coating using a spinner, spray coating, roll coating, screen printing, and a method using a blade coater, a die coater, a calendar coater, a meniscus coater, a bar coater, a roll coater, a comma roll coater, a gravure coater, a screen coater, or a slit die coater. The thickness of the resulting coating film varies depending on the application method as well as the solid content concentration, the viscosity, and the like of the composition; however, usually, from the standpoint of the coating film uniformity and the like, the post-drying film thickness is preferably 0.5 $\mu$m to 100 $\mu$m.

For drying, an oven, a hot plate, infrared rays, and the like can be used. The drying temperature and the drying time are not limited as long as they are in a range that allows volatilization of the solvent, and it is preferred to set the drying temperature and the drying time as appropriate such that the photosensitive resin composition is in an uncured or semi-cured state. Specifically, the drying is preferably performed in a range of 40°C to 150°C for 1 minute to several tens of minutes. The temperature may be raised in a stepwise manner using a combination of different temperatures in this range and, for example, a heat treatment may be performed at 80°C and 90°C for two minutes each.

A method for producing a relief pattern, which method includes the steps of: applying and drying the negative photosensitive resin composition of the present invention on a substrate; performing exposure; performing development

with an alkaline developer; and performing a heat treatment, will now be described.

The photosensitive resin composition of the present invention is applied to a substrate, or the above-described photosensitive sheet is laminated on a substrate. The substrate may be a copper-plated metal substrate, a silicon wafer, a silicon carbide substrate, or a gallium nitride substrate, and the material thereof may be, but are not limited to, ceramics, gallium arsenide, or the like. As an application method, for example, rotary coating using a spinner, spray coating, or roll coating may be employed. The thickness of the resulting coating film varies depending on the application method as well as the solid content concentration, the viscosity, and the like of the composition; however, the application is usually performed such that the post-drying film thickness is 0.1 to 150 μm.

In order to improve the adhesion between the substrate and the photosensitive resin composition, the substrate may be pre-treated with the above-described silane coupling agent. For example, 0.5 to 20% by mass of the silane coupling agent is dissolved in a solvent such as isopropanol, ethanol, methanol, water, tetrahydrofuran, propylene glycol monomethyl ether acetate, propylene glycol monomethyl ether, ethyl lactate, or diethyl adipate, and the substrate is surface-treated with the thus obtained solution by spin coating, immersion, spray coating, steam treatment, or the like. In some cases, a heat treatment up to 50°C to 300°C is subsequently performed to facilitate the reaction between the substrate and the silane coupling agent.

Next, the substrate on which the photosensitive resin composition has been applied or the photosensitive sheet of the present invention has been laminated is dried to obtain a photosensitive resin composition coating film. The drying is preferably performed using an oven, a hot plate, infrared rays, or the like in a temperature range of 50°C to 150°C for 1 minute to several hours. It is noted here that, in the case of using the photosensitive sheet, the drying step does not necessarily have to be performed.

Subsequently, the thus obtained photosensitive resin composition coating film is exposed by irradiation with an actinic radiation through a mask having a desired pattern. Examples of the actinic radiation used for the exposure include ultraviolet rays, visible light, electron beams, and X-rays; however, in the present invention, it is preferred to use i-line (365 nm), h-line (405 nm), or g-line (436 nm) emitted from a mercury lamp.

Thereafter, a post-exposure baking treatment is performed. The temperature of this baking treatment is preferably in a range of 50 to 180°C, particularly preferably in a range of 60 to 150°C. The time of this baking treatment is not particularly limited; however, from the standpoint of subsequent developability, it is preferably 10 seconds to several hours.

In order to form a resin pattern, after the exposure, exposed parts or unexposed parts are removed using a developer. The developer used for development is preferably a good solvent for the negative photosensitive resin composition, or a combination of the good solvent and a poor solvent. For example, in the case of a photosensitive resin composition that is soluble in an alkaline aqueous solution, the developer used for development dissolves and removes an alkaline aqueous solution-soluble polymer, and the developer is typically an alkaline aqueous solution in which an alkali compound is dissolved. Examples of the alkali compound include tetramethylammonium hydroxide, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, and hexamethylenediamine. In some cases, polar solvents such as N-methyl-2-pyrrolidone, N,N-dimethylformamide, N,N-dimethylacetamide, dimethyl sulfoxide, γ-butyrolactone, and dimethylacrylamide, alcohols such as methanol, ethanol, and isopropanol, esters such as ethyl lactate and propylene glycol monomethyl ether acetate, and ketones such as cyclopentanone, cyclohexanone, isobutyl ketone, and methyl isobutyl ketone, may be added singly, or in combination of several kinds thereof, to the alkaline aqueous solution.

After the development, it is preferred to perform rinsing with water. In the case of using water, an alcohol such as ethanol or isopropyl alcohol, or an ester such as ethyl lactate or propylene glycol monomethyl ether acetate may be added to the water to perform the rinsing.

After the development, a temperature of 150°C to 400°C is applied to facilitate a thermal crosslinking reaction and to thereby improve the heat resistance and the chemical resistance. This heat treatment is performed by selecting a temperature and raising the temperature in a stepwise manner, or by selecting a certain temperature range and continuously raising the temperature, for a period of 5 minutes to 5 hours. As an example, the heat treatment is performed at 130°C and 200°C for 30 minutes each. As for a curing condition in the present invention, a lower temperature limit is preferably 170°C or higher, and it is more preferably 180°C or higher for sufficient progress of curing. Meanwhile, an upper temperature limit of the curing condition is preferably 450°C or lower.

The cured article of the present invention is a cured article obtained by curing the photosensitive resin composition of the present invention.

The cured article can be obtained by applying the photosensitive resin composition to a substrate, drying the thus applied composition to volatilize the solvent, subsequently performing the exposure and post-exposure baking steps if necessary, and then curing the composition at a temperature of 150°C to 400°C. This heat treatment is performed by selecting a temperature and raising the temperature in a stepwise manner, or by selecting a certain temperature range and continuously raising the temperature, for a period of 5 minutes to 5 hours. As an example, the heat treatment is performed

at 130°C and 200°C for 30 minutes each. As for a curing condition in the present invention, a lower temperature limit is preferably 170°C or higher, and it is more preferably 180°C or higher for sufficient progress of curing. Meanwhile, an upper temperature limit of the curing condition is preferably 450°C or lower.

The electronic component of the present invention includes the cured article of the present invention.

The cured article formed from the photosensitive resin composition of the present invention can be used as an insulating film or a protective film that constitutes an electronic component.

Examples of the electronic component include: active components having a semiconductor, such as transistors, diodes, integrated circuits (ICs), and memories; and passive components, such as resistors, capacitors, and inductors. Electronic components in which a semiconductor is used are also called "semiconductor devices" or "semiconductor packages".

Specific examples of the cured article used in an electronic component include, but are not limited to: passivation films of semiconductors; surface protective films of semiconductor elements, TFTs (Thin Film Transistors), and the like; interlayer insulating films, such as interlayer insulating films between redistribution layers in 2 to 10 layers of high-density multilayer wiring for mounting; insulating films and protective films of touch panel displays; and insulating layers of organic electroluminescent devices, and the cured film can take a variety of structures.

The electronic component of the present invention preferably includes the cured article of the present invention on a substrate. The substrate surface on which the cured article is to be formed can be appropriately selected depending on the use and process. Examples of the substrate include silicon substrates, silicon carbide substrates, gallium nitride substrates, and substrates made of ceramics, gallium arsenide, metals, epoxy resins, and the like, and the substrate is preferably a silicon substrate, a silicon carbide substrate, or a gallium nitride substrate.

## Examples

The present invention will now be described by way of Examples; however, the present invention is not limited by the below-described Examples. First, the evaluation methods employed in Examples and Comparative Examples will be described. For evaluation, an uncured negative photosensitive resin composition (hereinafter, referred to as "varnish") which had been filtered in advance through a polytetrafluoroethylene filter having an average pore size of 1 μm (manufactured by Sumitomo Electric Industries, Ltd.) was used.

### (1) Weight-Average Molecular Weight of Alkali-Soluble Resin (A)

For the alkali-soluble resin or alkali-soluble resin solution that was obtained in each of Examples and Comparative Examples, the weight-average molecular weight (Mw) was measured in terms of polystyrene, using a GPC (gel permeation chromatography) apparatus WATERS 2690-996 (manufactured by Waters Corporation Japan) and N-methyl-2-pyrrolidone (hereinafter, abbreviated as "NMP") as a developing solvent.

### (2) Esterification Rate

Using a nuclear magnetic resonance (NMR) apparatus EX-270 (manufactured by JEOL Ltd.), $^1$H-NMR was measured for a mixed solution of 10 mg of the polyamic acid ester obtained in each of Examples and Comparative Examples and 0.8 g of deuterated dimethyl sulfoxide (DMSO-d6), and the integral value of a peak derived from aromatic protons of the resin was determined. The esterification rate of the polyamic acid ester was calculated from the area ratio of peaks derived from methyl protons and ethylene-type unsaturated double bond group of a carboxylic acid ester. Since resins other than a polyamic acid ester do not contain a carboxylic acid ester, their esterification rates are deemed unmeasurable and thus indicated as "-".

### (3) Evaluation of Content of β-alkoxypropionamide with Respect to Alkali-Soluble Resin (A)

In 0.7 g of deuterated dimethyl sulfoxide, 0.03 g of the alkali-soluble resin (A) obtained in each of Examples and Comparative Examples or 0.1 g of the alkali-soluble resin (A) solution obtained in each of Examples and Comparative Example, and 0.01 g of methyl 3-nitrobenzoate as an internal standard substance were dissolved, and the resultant was analyzed using an NMR apparatus GX-270 (manufactured by JEOL Ltd.). Based on the area of the peak derived from methyl 3-nitrobenzoate at about 3.9 ppm, the content [% by mass] of $\beta$-alkoxypropionamide with respect to the alkali-soluble resin (A) was measured from the area of each peak.

### (4) Evaluation of Fluorine Atom Content in Alkali-Soluble Resin (A)

The fluorine atom content [% by mass] of the component (A) obtained in each of Examples and Comparative

Examples was measured by combustion ion chromatography under the following measurement conditions. The component (A) or a solution of the component (A) was burned and decomposed in a combustion tube of an analyzer, and the generated gas was absorbed by an absorbing liquid, after which a portion of the absorbing liquid was analyzed by ion chromatography.

<Combustion and Absorption Conditions>

System: AQF-2100H, GA-210 (manufactured by Mitsubishi Chemical Corporation)
Electric furnace Temperature: inlet = 900°C, outlet = 1,000°C
Gas: $Ar/O_2$ = 200 mL/min, $O_2$ = 400 mL/min
Absorbing liquid: $H_2O_2$, 0.1%
Amount of absorbing liquid: 5 mL

<Ion Chromatography and Anion Analysis Conditions>

System: ICS1600 (manufactured by DIONEX Corporation)
Mobile phase: 2.7 mmol/L $Na_2CO_3$, 0.3 mmol/L $NaHCO_3$
Flow rate: 1.50 mL/min
Detector: electric conductivity detector
Injection amount: 100 μL

(5) Evaluation of i-line Transmittance of Negative Photosensitive Resin Composition

Each varnish was spin-coated on a glass substrate using a spin coater 1H-360S (manufactured by Mikasa Co., Ltd.), and then pre-baked at 100°C for 5 minutes on a hot plate (SCW-636, manufactured by Dainippon Screen Mfg. Co., Ltd.) to produce a pre-baked film having a thickness of 5 μm. The i-line transmittance of the thus obtained pre-baked film was measured from a transmitted UV spectrum using a spectrophotometer U-2910 (manufactured by Hitachi High-Tech Science Corporation).

(6) Sensitivity

The varnish obtained in each of Examples and Comparative Examples was applied onto an 8-inch silicon wafer by spin coating using a coating and development machine ACT-8 (manufactured by Tokyo Electron Ltd.), and then pre-baked at 100°C for 5 minutes to produce a pre-baked film having a thickness of 22.0 μm. The film thickness was measured using a LAMBDA ACE STM-602 manufactured by Dainippon Screen Mfg. Co., Ltd. at a refractive index of 1.63. Subsequently, using an exposure machine i-LINE STEPPER NSR-2005i9C (manufactured by Nikon Corporation), the pre-baked film was exposed in an exposure dose range of 100 to 2,000 $mJ/cm^2$ at 50-$mJ/cm^2$ intervals through 30-μm and 100-μm masks having a 1:1 line-and-space pattern. After the exposure, the film was baked at 120°C for 1 minute and then paddle-developed for 120 seconds using the ACT-8 development machine with a 2.38-wt% tetramethylammonium hydroxide aqueous solution (manufactured by Tama Chemicals Co., Ltd.; hereinafter, abbreviated as "TMAH") as a developer. Thereafter, the film was rinsed with distilled water and dried by shaking to obtain a pattern.

After the development, the film thickness was measured, and the minimum exposure dose at which the residual film ratio in the exposed parts exceeded 90% was defined as the sensitivity.

(7) Pattern Shape

A line-and-space pattern obtained in the same manner as in (6) above was heated from 50°C to 380°C over a period of 100 minutes in a nitrogen stream (oxygen concentration: 20 ppm or less) using an inert oven (manufactured by Koyo Thermo Systems Co., Ltd.), and the negative photosensitive resin composition layer of this pattern was cured at 380°C for 1 hour. The silicon wafer was cut perpendicular to the line pattern to expose a pattern cross-section. This pattern cross-section of L/S = 100/100 μm was observed under a light microscope at a magnification of ×200, and the pattern cross-sectional shape was evaluated. In the evaluation of the pattern shape in Examples and Comparative Examples, a taper angle formed by the surface of the silicon wafer (substrate surface) and a side surface of the pattern was measured, and the pattern shape was evaluated as: "A" when the taper angle was less than 90° but 85° or more; "B" when the taper

angle was less than 85° but 80° or more; "C" when the taper angle was less than 80° but 75° or more; "D" when the taper angle was less than 75° but 70° or more; or "E" when the taper angle was less than 70°. Further, in the evaluation of the pattern shape, when the pattern cross-sectional shape was a reverse taper shape having a taper angle of 90° or more, the pattern shape was evaluated as defective "F".

(8) Developer Adhesion

A pre-baked film having a thickness of 22.0 μm was formed on an 8-inch silicon wafer in the same manner as in (6). Subsequently, using an exposure machine i-LINE STEPPER NSR-2005i9C (manufactured by Nikon Corporation), the pre-baked film was exposed at the minimum exposure dose determined in the above-described sensitivity evaluation through a mask having convex patterns (islands) of a smallest size of 1 $\mu m^2$ to a largest size of 100 $\mu m^2$ at 5-$\mu m^2$ intervals. After the exposure, the film was paddle-developed using the ACT-8 development machine with a 2.38-wt% TMAH as a developer, and then rinsed with distilled water and dried by shaking to obtain a pattern.

The thus obtained pattern was observed under an FDP microscope MX61 (manufactured by Olympus Corporation) at a magnification of ×20, and the minimum size of a convex pattern tightly adhered to the substrate without peeling was examined. The smaller the size of a convex pattern tightly adhered to the substrate without peeling, the higher is the developer adhesion.

(9) Storage Stability

The viscosity (initial) of the varnish obtained in each of Examples and Comparative Examples was measured using an E-type viscometer. After the varnish was stored in a closed container at 25°C for 2 weeks, the viscosity (2w) was measured using an E-type viscometer. The viscosity change rate was calculated using the following equation. The lower the viscosity change rate, the higher is the storage stability.

$$\text{Viscosity change rate} = |100 \times \{1 - (\text{Viscosity (2w)}/\text{Viscosity (initial)})\}|$$

A: The viscosity change rate was lower than 10%.
B: The viscosity change rate was 10% or higher but lower than 15%.
C: The viscosity change rate was 15% or higher but lower than 20%.
D: The viscosity change rate was 20% or higher.

(10) Heat Resistance (Measurement of 5% Weight Loss Temperature)

Each photosensitive resin composition was treated in the same manner as in (7) above, except that the entire surface of the photosensitive resin composition was exposed without using a photomask, whereby a cured film of the photosensitive resin composition was produced. The thus obtained cured film was peeled off from the silicon wafer to produce a single film. The 5% weight loss temperature of the thus produced cured film was measured using a differential thermal and thermogravimetric simultaneous measuring device DTG-60A (manufactured by Shimadzu Corporation). It is noted here that this measurement was performed under the following conditions: test temperature = room temperature (25°C) to 550°C; heating rate = 10°C/min; measurement atmosphere = nitrogen; and sample weight = 15 mg. The heat resistance in Examples and Comparative Examples was evaluated based on the 5% weight loss temperature of the single film (cured film) measured in this manner, and the measured 5% weight loss temperature [°C] was used as the evaluation result.

(11) Method for Producing Polymer of Component (C), and Method for Measuring Residue after Heating of Polymer Using Thermogravimetric Analyzer in Nitrogen Atmosphere from Room Temperature to 380°C at Heating Rate of 10°C/min and Subsequent 1-Hour Heat Treatment at 380°C

The component (C) in an amount of 2 g was placed in an aluminum cup, and 3 g of a 0.4%-by mass propylene glycol monomethyl ether acetate solution of azobisisobutyronitrile was added thereto, after which the resultant was heated at 130°C for 10 minutes on a hot plate, subsequently heated to 200°C, and further heated for 30 minutes after reaching 200°C, whereby a polymer of the component (C) was obtained.

For the thus produced polymer of the component (C), the residual rate after 1-hour heat treatment at 380°C was measured using a differential thermal and thermogravimetric simultaneous measuring device DTG-60A (manufactured by Shimadzu Corporation). It is noted here that this measurement was performed under the following conditions: test temperature = room temperature (25°C) to 380°C, holding at 380°C for 1 hour; heating rate = 10°C/min; measurement

atmosphere = nitrogen; and sample weight = 15 mg.

<Synthesis Example 1: Synthesis of Diamine Compound Containing Hydroxyl Groups (HA)>

First, 18.3 g (0.05 mol) of 2,2-bis(3-amino-4-hydroxyphenyl)hexafluoropropane (manufactured by Central Glass Co., Ltd.; hereinafter, abbreviated as "BAHF") was dissolved in 100 mL of acetone and 17.4 g (0.3 mol) of propylene oxide (manufactured by Tokyo Chemical Industry Co., Ltd.), and the resultant was cooled to -15°C. A solution prepared by dissolving 20.4 g (0.11 mol) of 3-nitrobenzoyl chloride (manufactured by Tokyo Chemical Industry Co., Ltd.) in 100 mL of acetone was added dropwise thereto. After the completion of this dropwise addition, the resultant was stirred at -15°C for 4 hours, and then brought back to room temperature. The thus precipitated white solid was separated by filtration and vacuum-dried at 50°C.

Next, 30 g of the thus obtained white solid was placed in a 300-mL stainless steel autoclave, and dispersed in 250 mL of methyl cellosolve, followed by addition of 2 g of 5% palladium on carbon (manufactured by Wako Pure Chemical Industries, Ltd.). Hydrogen was introduced to the resultant using a balloon to perform a reduction reaction at room temperature. After a lapse of about 2 hours, the reaction was terminated when no further deflation of the balloon was confirmed. Thereafter, the palladium compound used as a catalyst was removed by filtration, and the resultant was concentrated using a rotary evaporator, whereby a diamine compound containing hydroxyl groups (HA), which is represented by the following formula, was obtained.

[Chem. 29]

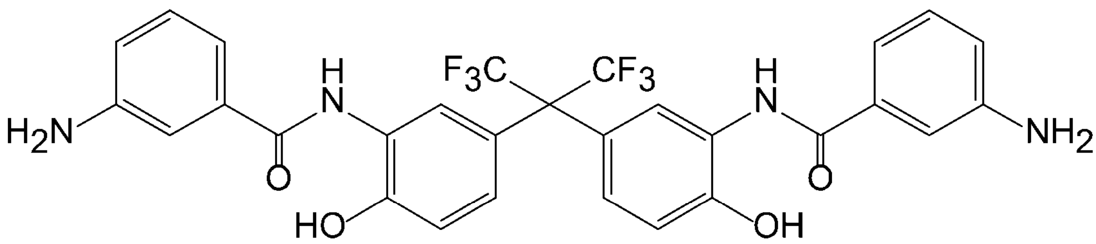

<Synthesis Example 2: Synthesis of Polyimide Precursor (PAA-1)>

In a dry nitrogen stream, 51.4 g (0.085 mol) of the diamine compound containing hydroxyl groups (HA) obtained in Synthesis Example 1 and 1.2 g (0.005 mol) of 1,3-bis(3-aminopropyl)tetramethyldisiloxane (hereinafter, abbreviated as "SiDA") were dissolved in 200 g of NMP. To the resultant, 31.0 g (0.100 mol) of 4,4'-oxydiphthalic anhydride (hereinafter, abbreviated as "ODPA") was added, followed by stirring at 40°C for 2 hours. Then, 2.2 g (0.02 mol) of 3-aminophenol (manufactured by Tokyo Chemical Industry Co., Ltd., hereinafter, abbreviated as "MAP") was added as an end-capping agent along with 10 g of NMP, and the resultant was allowed to react at 40°C for 1 hour. Subsequently, a solution obtained by diluting 17.9 g (0.15 mol) of dimethylformamide dimethyl acetal (manufactured by Mitsubishi Rayon Co., Ltd.; hereinafter, abbreviated as "DFA") with 10 g of NMP was added dropwise. After this dropwise addition, stirring was continued at 40°C for 2 hours. Thereafter, the resulting solution was added to 2 L of water, and the thus formed polymer solid precipitate was collected by filtration. The solution was further washed with 2 L of water three times, and the thus collected polymer solid was dried in a 50°C vacuum dryer for 72 hours, whereby a polyimide precursor (PAA-1) was obtained.

<Synthesis Example 3: Synthesis of Polyimide Precursor (PAA-2)>

A polyimide precursor (PAA-2) was obtained in the same manner as in Synthesis Example 2, except that the amount of DFA was changed from 17.9 g (0.15 mol) to 21.5 g (0.18 mol).

<Synthesis Example 4: Synthesis of Polyimide Precursor (PAA-3)>

A polyimide precursor (PAA-3) was obtained in the same manner as in Synthesis Example 2, except that the amount of DFA was changed from 17.9 g (0.15 mol) to 23.8 g (0.20 mol).

<Synthesis Example 5: Synthesis of Polyimide Precursor (PAA-4)>

In a 2-L separable flask, 24.8 g (0.08 mol) of ODPA was placed, and 21.9 g (0.17 mol) of 2-hydroxyethyl methacrylate (HEMA) and 310 g of 3-methoxy-*N,N*-dimethylpropaneamide (manufactured by KJ Chemicals Corporation; hereinafter, abbreviated as "MPA") were added. While stirring the resultant at room temperature, 12.7 g (0.16 mol) of pyridine was added to obtain a reaction mixture (ODPA-HEMA). After the heat generation by the reaction stopped, the reaction mixture was allowed to cool to room temperature and left to stand for 16 hours.

Next, under ice cooling, a solution obtained by dissolving 28.9 g (0.14 mol) of dicyclohexylcarbodiimide (DCC) in 180 g of MPA was added to the reaction mixture with stirring over a period of 40 minutes. Then, a suspension obtained by suspending 114.9 g (0.19 mol) of HA and 2.5 g (0.01 mol) of SiDA in 230 g of MPA was added with stirring over a period of 60 minutes. After this reaction mixture was stirred at room temperature for another 2 hours, 31.0 g (0.16 mol) of ODPA was added and, after stirring was continued at room temperature for 3 hours, 4.3 g (0.04 mol) of MAP was added. After stirring was further continued at room temperature for 1 hour, the precipitate generated in the reaction mixture was removed by filtration to obtain a reaction solution.

The thus obtained reaction solution was added to 3 L of water to obtain a white precipitate. This precipitate was collected by filtration, washed with water twice and then with isopropanol once, and subsequently dried in a 50°C vacuum dryer for 72 hours, whereby a polyimide precursor (PAA-4) was obtained.

<Synthesis Example 6: Synthesis of Polyimide Precursor (PAA-5)>

A polyimide precursor (PAA-5) was obtained in the same manner as in Synthesis Example 4, except that NMP was changed to MPA.

<Synthesis Example 7: Synthesis of Polybenzoxazole Precursor (PHA-1)>

In a dry nitrogen stream, 34.8 g (0.1 mol) of BAHF and 1.2 g (0.01 mol) of SiDA were dissolved in 200 g of NMP. Subsequently, while maintaining the temperature at 0 to 5°C, 23.6 g (0.08 mol) of 4,4'-oxybenzoyl chloride was added along with 50 g of NMP, and the resultant was allowed to react for 1 hour. Next, the temperature was brought back to room temperature, and 6.6 g (0.04 mol) of 5-norbornene-2,3-dicarboxylic anhydride was added along with 10 g of NMP, and the resultant was allowed to react for another 1 hour. Thereafter, the resulting solution was added to 3.0 L of water to obtain a white precipitate. This precipitate was collected by filtration, washed with water three times, and then dried in a 50°C circulation dryer for 3 days, whereby a powder of a polybenzoxazole precursor (PHA-1) was obtained.

<Synthesis Example 8: Synthesis of Polybenzoxazole Precursor (PHA-2)>

A polybenzoxazole precursor (PHA-2) was obtained in the same manner as in Synthesis Example 6, except that NMP was changed to MPA.

<Synthesis Example 9: Synthesis of Polyimide (PI-1)>

In a dry nitrogen stream, 29.3 g (0.08 mol) of BAHF, 1.2 g (0.005 mol) of SiDA, and 3.3 g (0.03 mol) of MAP as an end-capping agent were dissolved in 80 g of NMP. Subsequently, 31.2 g (0.1 mol) of ODPA was added along with 20 g of NMP, and the resultant was allowed to react at 60°C for 1 hour, followed by stirring at 180°C for 4 hours. Thereafter, the resulting solution was added to 3 L of water to obtain a white precipitate. This precipitate was collected by filtration, washed with water three times, and then dried in an 80°C vacuum dryer for 20 hours, whereby a powder of a polyimide (PI-1) was obtained.

<Synthesis Example 10: Synthesis of Polyimide Precursor (PAA-6)>

In a dry nitrogen stream, 23.8 g (0.07 mol) of BAHF, 4 g (0.02 mol) of 4,4'-diaminodiphenyl ether (DAE), and 1.2 g (0.01 mol) of SiDA were dissolved in 200 g of NMP. To the resultant, 31.0 g (0.100 mol) of ODPA was added, followed by stirring at 40°C for 2 hours. Then, 2.2 g (0.02 mol) of MAP was added as an end-capping agent along with 10 g of NMP, and the resultant was allowed to react at 40°C for 1 hour. Subsequently, a solution obtained by diluting 23.8 g (0.20 mol) of DFA with 10 g of NMP was added dropwise. After this dropwise addition, stirring was continued at 40°C for 2 hours. Thereafter, the resulting solution was added to 2 L of water, and the thus formed polymer solid precipitate was collected by filtration. The solution was further washed with 4 L of water three times, and the thus collected polymer solid was dried in a 50°C vacuum dryer for 72 hours, whereby a polyimide precursor (PAA-6) was obtained.

<Synthesis Example 11: Synthesis of Polyimide Precursor (PAA-7)>

In a dry nitrogen stream, 17.0 g (0.085 mol) of DAE and 1.2 g (0.005 mol) of SiDA were dissolved in 142 g of NMP. To the resultant, 31.0 g (0.100 mol) of ODPA was added, followed by stirring at 40°C for 2 hours. Then, 2.2 g (0.02 mol) of MAP was added as an end-capping agent along with 10 g of NMP, and the resultant was allowed to react at 40°C for 1 hour. Subsequently, a solution obtained by diluting 17.9 g (0.15 mol) of DFA with 10 g of NMP was added dropwise. After this dropwise addition, stirring was continued at 40°C for 2 hours. Thereafter, the resulting solution was added to 2 L of water, and the thus formed polymer solid precipitate was collected by filtration. The solution was further washed with 2 L of water three times, and the thus collected polymer solid was dried in a 50°C vacuum dryer for 72 hours, whereby a polyimide precursor (PAA-7) was obtained.

<Synthesis Example 12: Synthesis of Polyimide Precursor (PAA-8)>

A polyimide precursor (PAA-8) was obtained in the same manner as in Synthesis Example 2, except that the amount of DFA was changed from 17.9 g (0.15 mol) to 29.8 g (0.25 mol).

<Synthesis Example 13: Synthesis of Polyimide Precursor (PAA-9)>

A polyimide precursor (PAA-9) was obtained in the same manner as in Synthesis Example 11, except that the amount of DFA was changed from 17.9 g (0.15 mol) to 20.3 g (0.17 mol).

<Synthesis Example 14: Synthesis of Polyimide Precursor (PAA-10)>

A polyimide precursor (PAA-10) was obtained in the same manner as in Synthesis Example 11, except that the amount of DFA was changed from 17.9 g (0.15 mol) to 25.0 g (0.21 mol).

<Synthesis Example 15: Synthesis of Polyimide Precursor (PAA-11)>

A polyimide precursor (PAA-11) was obtained in the same manner as in Synthesis Example 11, except that the amount of DFA was changed from 17.9 g (0.15 mol) to 26.2 g (0.22 mol).

<Synthesis Example 16: Synthesis of Polybenzoxazole Precursor (PHA-3)>

In a dry nitrogen stream, 24.5 g (0.095 mol) of 2,2-bis(3-amino-4-hydroxyphenyl)propane and 1.2 g (0.005 mol) of SiDA were dissolved in 70 g of NMP. Subsequently, while maintaining the temperature at 0 to 5°C, 23.6 g (0.08 mol) of 4,4'-oxybenzoyl chloride was added along with 50 g of NMP, and the resultant was allowed to react for 1 hour. Next, the temperature was brought back to room temperature, and 6.6 g (0.04 mol) of 5-norbornene-2,3-dicarboxylic anhydride was added along with 10 g of NMP, and the resultant was allowed to react for another 1 hour. Thereafter, the resulting solution was added to 3.0 L of water to obtain a white precipitate. This precipitate was collected by filtration, washed with water three times, and then dried in a 50°C circulation dryer for 3 days, whereby a powder of a polybenzoxazole precursor (PHA-3) was obtained.

<Synthesis Example 17: Synthesis of Polyimide Precursor (PAA-12)>

A polyimide precursor (PAA-12) was obtained in the same manner as in Synthesis Example 14, except that NMP was changed to MPA.

<Synthesis Example 18: Synthesis of Polybenzoxazole Precursor (PHA-4)>

A polybenzoxazole precursor (PHA-4) was obtained in the same manner as in Synthesis Example 16, except that NMP was changed to MPA.

Table 1 shows the constituents (molar ratios) of Synthesis Examples 2 to 18, and the measurement results of the molecular weight (Mw), the fluorine concentration, the esterification rate, and the content of $\beta$-alkoxypropionamide (contained as an impurity in the obtained powder).

[Table 1]

| | (A) Alkalin Soluble Resin | Tetra carboxylic acid and its derivatives (mol rate) | | Diamine and its Derivatives (mol rate) | | | Terminal-capping Agent (mol rate) | Solvent | Resin Evaluation | | | |
|---|---|---|---|---|---|---|---|---|---|---|---|---|
| | | | | | | | | | Mw Note 1) | Fluorine Concentration [mass%] | Esterification Rate [%] | β-alkoxy propion amide Concentration [mass%] |
| Synthetic Example 2 | Polyimide Precursor (PAA-1) | ODPA (100) | - | HA (85) | - | SiDA (5) | MAP (20) | NMP | 30,000 | 10.1 | 36 | - |
| Synthetic Example 3 | Polyimide Precursor (PAA-2) | ODPA (100) | - | HA (85) | - | SiDA (5) | MAP (20) | NMP | 33,000 | 10.1 | 42 | - |
| Synthetic Example 4 | Polyimide Precursor (PAA-3) | ODPA (100) | - | HA (85) | - | SIDA (5) | MAP (20) | NMP | 33,000 | 10.1 | 76 | - |
| Synthetic Example 5 | Polyimide Precursor (PAA-4) | ODPA-HEMA (50) | ODPA (50) | HA (85) | - | SiDA (5) | MAP (20) | MPA | 25,000 | 9.1 | 40 | 4.5 |
| Synthetic Example 6 | Polyimide Precursor (PAA-5) | ODPA (100) | - | HA (85) | - | SiDA (5) | MAP (20) | MPA | 34,000 | 10.1 | 68 | 4.2 |
| Synthetic Example 7 | Polybenzoxazol Precursor (PHA-1) | OBBOC (80) | - | BAHF (95) | - | SIDA (5) | NA (40) | NMP | 25,000 | 18 | - | - |
| Synthetic Example 8 | PolybenzoxazolPrecursor (PHA-2) | OBBOC (80) | - | BAHF (95) | - | SiDA (5) | NA (40) | MPA | 25,000 | 18 | - | 3.2 |
| Synthetic Example 9 | Polyimide (PI-1) | ODPA (100) | - | BAHF (85) | - | SiDA (5) | MAP (20) | NMP | 25,000 | 14.1 | - | - |
| Synthetic Example 10 | Polyimide Precursor (PAA-6) | ODPA (100) | - | BAHF (65) | DAE (20) | SiDA (5) | MAP (20) | NMP | 15,000 | 6 | 70 | - |

(continued)

| | (A) Alkalin Soluble Resin | Tetra carboxylic acid and its derivatives (mol rate) | | Diamine and its Derivatives (mol rate) | | | Terminal-capping Agent (mol rate) | Solvent | Resin Evaluation | | | |
|---|---|---|---|---|---|---|---|---|---|---|---|---|
| | | | | | | | | | Mw Note 1) | Fluorine Concentration [mass%] | Esterification Rate [%] | β-alkoxy propion amide Concentration [mass%] |
| Synthetic Example 11 | Polyimide Precursor (PAA-7) | ODPA (100) | - | DAE (85) | - | SiDA (5) | MAP (20) | NMP | 24,000 | 0 | 38 | - |
| Synthetic Example 12 | Polyimide Precursor (PAA-8) | ODPA (100) | - | HA (85) | - | SiDA (5) | MAP (20) | NMP | 33,000 | 10.1 | 84 | - |
| Synthetic Example 13 | Polyimide Precursor (PAA-9) | ODPA (100) | - | DAE (85) | - | SIDA (5) | MAP (20) | NMP | 24,000 | 0 | 43 | - |
| Synthetic Example 14 | Polyimide Precursor (PAA-10) | ODPA (100) | - | DAE (85) | - | SIDA (5) | MAP (20) | NMP | 24,000 | 0 | 78 | - |
| Synthetic Example 15 | Polyimide Precursor (PAA-11) | ODPA (100) | - | DAE (85) | - | SIDA (5) | MAP (20) | NMP | 24,000 | 0 | 82 | - |
| Synthetic Example 16 | Polybenzoxazol Precursor (PHA-3) | OBBOC (80) | - | BAP (95) | - | SIDA (5) | NA (40) | NMP | 25,000 | 0 | - | - |
| Synthetic Example 17 | Polyimide Precursor (PAA-12) | ODPA (100) | - | DAE (85) | - | SIDA (5) | MAP (20) | MPA | 24,000 | 0 | 72 | 4.0 |
| Synthetic Example 18 | Polybenzoxazol Precursor PHA-4 | OBBOC (80) | - | BAP (95) | - | SIDA (5) | NA (40) | MPA | 25,000 | 0 | - | 3.8 |

Note 1) Mw: Weight Average Molucular Weight

Note) The abbreviations used in Table 1 are as follows.

HA: diamine compound containing hydroxyl groups
ODPA: 4,4'-oxydiphthalic anhydride
ODPA-HEMA: a reaction mixture of 4,4'-oxydiphthalic anhydride and 2-hydroxyethyl methacrylate
SiDA: 1,3-bis(3-aminopropyl)tetramethyldisiloxane
BAHF: 2,2-bis(3-amino-4-hydroxyphenyl)hexafluoropropane
MAP: 3-aminophenol
DAE: 4,4'-diaminodiphenyl ether
MPA: 3-methoxy-*N,N*-dimethylpropaneamide
OBBOC: 4,4'-oxybenzoyl chloride
BAP: 2,2-bis(3-amino-4-hydroxyphenyl)propane
NA: 5-norbornene-2,3-dicarboxylic anhydride

<Examples and Comparative Examples>

The components shown in the tables below were mixed to obtain each resin composition. In Tables 2-1 to 2-3, the values in parentheses indicate the solid content (parts by mass) of each component. The $\beta$-alkoxypropionamide in Examples 11, 13, 14, 55, and 56 is an impurity contained in the component (A) used. In Examples 57 to 59, 3-methoxy-*N,N*-dimethylpropaneamide (manufactured by KJ Chemicals Corporation) was added as the $\beta$-alkoxypropionamide. Using GBL as a solvent, each composition was prepared such that the solid content concentration was 50% by mass.

[Table 2-1]

| | (A) Component (Content) | β-alkoxy propion amide (Content) | (B) Component (Content) | Photo Polymerization Initiator other than (B) Component (Content) | Content of (C) Components | | | | | (D) Component (Content) | Thioxanthone type (D) Component (Content) | Solvent |
|---|---|---|---|---|---|---|---|---|---|---|---|---|
| | | | | | (C-1) Component | (C-2) Component | (C-3) Component | (C-4) Component | Other (C) Component | | | |
| Example 1 | (PAA-1) (100 PHR) | - | (b-1) (15 PHR) | - | (c-1) 70 PHR | - | - | - | - | (d-1) (1.5 PHR) | - | GBL |
| Example 2 | (PAA-1) (100 PHR) | - | (b-2) (15 PHR) | - | (c-1) 70 PHR | - | - | - | - | (d-1) (1.5 PHR) | - | GBL |
| Example 3 | (PAA-1) (100 PHR) | - | (b-2) (15 PHR) | - | (c-1) 67 PHR | (c-2) 3 PHR | - | - | - | (d-1) (1.5 PHR) | - | GBL |
| Example 4 | (PAA-1) (100 PHR) | - | (b-2) (15 PHR) | - | (c-1) 56 PHR | (c-2) 14 PHR | - | - | - | (d-1) (1.5 PHR) | - | GBL |
| Example 5 | (PAA-1) (100 PHR) | - | (b-2) (15 PHR) | - | (c-1) 52 PHR | (c-2) 17 PHR | (c-3) 1 PHR | - | - | (d-1) (1.5 PHR) | - | GBL |
| Example 6 | (PAA-1) (100 PHR) | - | (b-2) (15 PHR) | - | (c-1) 40 PHR | (c-2) 15 PHR | (c-3) 15 PHR | - | - | (d-1) (1.5 PHR) | - | GBL |
| Example 7 | (PAA-1) (100 PHR) | - | (b-2) (15 PHR) | - | (c-1) 42 PHR | (c-2) 14 PHR | (c-3) 14 PHR | - | - | - | (d-2) (0.75 PHR) | GBL |
| Example 8 | (PAA-1) (100 PHR) | - | (b-2) (15 PHR) | - | (c-1) 42 PHR | (c-2) 14 PHR | (c-3) 14 PHR | - | - | - | (d-2) (0.5 PHR) | GBL |
| Example 9 | (PAA-2) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 10 | (PAA-3) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 11 | (PAA-4) (100 PHR) | present (4.7 PHR) | (b-2) (5 PHR) | - | (c-1) 42 PHR | (c-2) 14 PHR | (c-3) 14 PHR | - | - | - | (d-2) (0.5 PHR) | GBL |
| Example 12 | (PHA-1) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 13 | (PAA-5) (100 PHR) | present (4.4 PHR) | (b-2) (5 PHR) | - | (c-1) 42 PHR | (c-2) 14 PHR | (c-3) 14 PHR | - | - | - | (d-2) (0.5 PHR) | GBL |

(continued)

| | (A) Component (Content) | β-alkoxy propion amide (Content) | (B) Component (Content) | Photo Polymerization Initiator other than (B) Component (Content) | Content of (C) Components | | | | | (D) Component (Content) | Thioxanthone type (D) Component (Content) | Solvent |
|---|---|---|---|---|---|---|---|---|---|---|---|---|
| | | | | | (C-1) Component | (C-2) Component | (C-3) Component | (C-4) Component | Other (C) Component | | | |
| Example 14 | (PHA-2) (100 PHR) | present (3.3 PHR) | (b-2) (5 PHR) | - | (c-1) 42 PHR | (c-2) 14 PHR | (c-3) 14 PHR | - | - | - | (d-2) (0.5 PHR) | GBL |
| Example 15 | (PAA-6) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 16 | (PAA-7) (100 PHR) | - | (b-1) (15 PHR) | - | (c-1) 70 PHR | - | - | - | - | (d-1) (1.5 PHR) | - | GBL |
| Example 17 | (PAA-7) (100 PHR) | - | (b-2) (15 PHR) | - | (c-1) 70 PHR | - | - | - | - | (d-1) (1.5 PHR) | - | GBL |
| Example 18 | (PAA-1) (100 PHR) | - | (b-2) (15 PHR) | - | (c-1) 58 PHR | (c-2) 12 PHR | - | - | - | (d-1) (1.5 PHR) | - | GBL |
| Example 19 | (PAA-1) (100 PHR) | - | (b-2) (15 PHR) | - | (c-1) 54 PHR | (c-2) 16 PHR | - | - | - | (d-1) (1.5 PHR) | - | GBL |
| Example 20 | (PAA-7) (100 PHR) | - | (b-2) (15 PHR) | - | (c-1) 67 PHR | (c-2) 3 PHR | - | - | - | (d-1) (1.5 PHR) | - | GBL |

[Table 2-2]

| | (A) Component (Content) | β-alkoxy propion amide (Content) | (B) Component (Content) | Photo Polymerization Initiator other than (B) Component (Content) | Content of (C) Components | | | | | (D) Component (Content) | Thioxanthone type (D) Component (Content) | Solvent |
|---|---|---|---|---|---|---|---|---|---|---|---|---|
| | | | | | (C-1) Component | (C-2) Component | (C-3) Component | (C-4) Component | Other (C) Component | | | |
| Example 21 | (PAA-7) (100 PHR) | - | (b-2) (15 PHR) | - | (c-1) 58 PHR | (c-2) 12 PHR | - | - | - | (d-1) (1.5 PHR) | - | GBL |
| Example 22 | (PAA-7) (100 PHR) | - | (b-2) (15 PHR) | - | (c-1) 56 PHR | (c-2) 14 PHR | - | - | - | (d-1) (1.5 PHR) | - | GBL |
| Example 23 | (PAA-7) (100 PHR) | - | (b-2) (15 PHR) | - | (c-1) 54 PHR | (c-2) 16 PHR | - | - | - | (d-1) (1.5 PHR) | - | GBL |
| Example 24 | (PAA-1) (100 PHR) | - | (b-2) (15 PHR) | - | - | (c-2) 8 PHR | - | (c-5) 62 PHR | - | (d-1) (1.5 PHR) | - | GBL |
| Example 25 | (PAA-1) (100 PHR) | - | (b-2) (15 PHR) | - | - | (c-2) 15 PHR | - | (c-5) 55 PHR | - | (d-1) (1.5 PHR) | - | GBL |
| Example 26 | (PAA-1) (100 PHR) | - | (b-2) (15 PHR) | - | - | (c-2) 20 PHR | - | (c-5) 50 PHR | - | (d-1) (1.5 PHR) | - | GBL |
| Example 27 | (PAA-1) (100 PHR) | - | (b-2) (15 PHR) | - | - | (c-2) 25 PHR | - | (c-5) 45 PHR | - | (d-1) (1.5 PHR) | - | GBL |
| Example 28 | (PAA-7) (100 PHR) | - | (b-2) (15 PHR) | - | - | (c-2) 8 PHR | - | (c-5) 62 PHR | - | (d-1) (1.5 PHR) | - | GBL |
| Example 29 | (PAA-7) (100 PHR) | - | (b-2) (15 PHR) | - | - | (c-2) 15 PHR | - | (c-5) 55 PHR | - | (d-1) (1.5 PHR) | - | GBL |
| Example 30 | (PAA-7) (100 PHR) | - | (b-2) (15 PHR) | - | - | (c-2) 20 PHR | - | (c-5) 50 PHR | - | (d-1) (1.5 PHR) | - | GBL |
| Example 31 | (PAA-7) (100 PHR) | - | (b-2) (15 PHR) | - | - | (c-2) 25 PHR | - | (c-5) 45 PHR | - | (d-1) (1.5 PHR) | - | GBL |
| Example 32 | (PAA-1) (100 PHR) | - | (b-2) (15 PHR) | - | - | - | - | (c-5) 70 PHR | - | (d-1) (1.5 PHR) | - | GBL |
| Example 33 | (PAA-1) (100 PHR) | - | (b-2) (15 PHR) | - | - | - | - | - | (c-6) 70 PHR | (d-1) (1.5 PHR) | - | GBL |

(continued)

| | (A) Component (Content) | β-alkoxy propion amide (Content) | (B) Component (Content) | Photo Polymerization Initiator other than (B) Component (Content) | Content of (C) Components | | | | | (D) Component (Content) | Thioxanthone type (D) Component (Content) | Solvent |
|---|---|---|---|---|---|---|---|---|---|---|---|---|
| | | | | | (C-1) Component | (C-2) Component | (C-3) Component | (C-4) Component | Other (C) Component | | | |
| Example 34 | (PAA-7) (100 PHR) | - | (b-2) (15PHR) | - | - | - | - | (c-5) 70 PHR | - | (d-1) (1.5 PHR) | - | GBL |
| Example 35 | (PAA-7) (100 PHR) | - | (b-2) (15 PHR) | - | - | - | - | - | (c-6) 70 PHR | (d-1) (1.5 PHR) | - | GBL |
| Example 36 | (PAA-1) (100 PHR) | - | (b-2) (15 PHR) | - | (c-1) 52 PHR | (c-2) 17.6 PHR | (c-3) 0.4 PHR | - | - | (d-1) (1.5 PHR) | - | GBL |
| Example 37 | (PAA-1) (100 PHR) | - | (b-2) (15 | - | (c-1) 40 PHR | (c-2) 12 PHR | (c-3) 18 PHR | - | - | (d-1) (1.5 PHR) | - | GBL |
| Example 38 | (PAA-7) (100 PHR) | - | (b-2) (15 PHR) | - | (c-1) 52 PHR | (c-2) 17.6 PHR | (c-3) 0.4 PHR | - | - | (d-1) (1.5 PHR) | - | GBL |
| Example 39 | (PAA-7) (100 PHR) | - | (b-2) (15 PHR) | - | (c-1) 52 PHR | (c-2) 17 PHR | (c-3) 1 PHR | - | - | (d-1) (1.5 PHR) | - | GBL |
| Example 40 | (PAA-7) (100 PHR) | - | (b-2) (15 PHR) | - | (c-1) 40 PHR | (c-2) 15 PHR | (c-3) 15 PHR | - | - | (d-1) (1.5 PHR) | - | GBL |

[Table 2-3]

| | (A) Component (Content) | β-alkoxy propion amide (Content) | (B) Component (Content) | Photo Polymerization Initiator other than (B) Component (Content) | Content of (C) Component | | | | | (D) Component (Content) | Thioxanthone type (D) Component (Content) | Solvent |
|---|---|---|---|---|---|---|---|---|---|---|---|---|
| | | | | | (C-1) Component | (C-2) Component | (C-3) Component | (C-4) Component | Other (C) Component | | | |
| Example 41 | (PAA-7) (100 PHR) | - | (b-2) (15 PHR) | - | (c-1) 40 PHR | (c-2) 12 PHR | (c-3) 15 PHR | - | - | (d-1) (1.5 PHR) | - | GBL |
| Example 42 | (PAA-1) (100 PHR) | - | (b-2) (15 PHR) | - | (c-1) 42 PHR | (c-2) 14 PHR | (c-3) 14 PHR | - | - | - | (d-2) (4.5 PHR) | GBL |
| Example 43 | (PAA-1) (100 PHR) | - | (b-2) (15 PHR) | - | (c-1) 42 PHR | (c-2) 14 PHR | (c-3) 14 PHR | - | - | - | (d-2) (5 PHR) | GBL |
| Example 44 | (PAA-7) (100 PHR) | - | (b-2) (15 PHR) | - | (c-1) 42 PHR | (c-2) 14 PHR | (c-3) 14 PHR | - | - | - | (d-2) (0.5 PHR) | GBL |
| Example 45 | (PAA-7) (100 PHR) | - | (b-2) (15 PHR) | - | (c-1) 42 PHR | (c-2) 14 PHR | (c-3) 14 PHR | - | - | - | (d-2) (0.75 PHR) | GBL |
| Example 46 | (PAA-7) (100 PHR) | - | (b-2) (15 PHR) | - | (c-1) 42 PHR | (c-2) 14 PHR | (c-3) 14 PHR | - | - | - | (d-2) (4.5 PHR) | GBL |
| Example 47 | (PAA-7) (100 PHR) | - | (b-2) (15 PHR) | - | (c-1) 42 PHR | (c-2) 14 PHR | (c-3) 14 PHR | - | - | - | (d-2) (5 PH R) | GBL |
| Example 48 | (PAA-2) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 49 | (PAA-8) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 50 | (PAA-7) (100 PHR) | - | (b-2) (5 PHR) | - | (c-1) 42 PHR | (c-2) 14 PHR | (c-3) 14PHR | - | - | - | (d-2) (0.5 PHR) | GBL |
| Example 51 | (PAA-9) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 52 | (PAA-10) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 53 | (PAA-11) (100 PHR) | - | (b-2) (5 PHR) | - | (c-1) 42 PHR | (c-2) 14 PHR | (c-3) 14 PHR | - | - | - | (d-2) (0.5 PHR) | GBL |

(continued)

| | (A) Component (Content) | β-alkoxy propion amide (Content) | (B) Component (Content) | Photo Polymerization Initiator other than (B) Component (Content) | Content of (C) Component | | | | | (D) Component (Content) | Thioxanthone type (D) Component (Content) | Solvent |
|---|---|---|---|---|---|---|---|---|---|---|---|---|
| | | | | | (C-1) Component | (C-2) Component | (C-3) Component | (C-4) Component | Other (C) Component | | | |
| Example 54 | (PHA-3) (100 PHR) | - | (b-2) (5 PHR) | - | (c-1) 42 PHR | (c-2) 14 PHR | (c-3) 14 PHR | - | - | - | (d-2) (0.5 PHR) | GBL |
| Example 55 | (PAA-12) (100 PHR) | present (4 PHR) | (b-2) (5 PHR) | - | (c-1) 42 PHR | (c-2) 14 PHR | (c-3) 14 PHR | - | - | - | (d-2) (0.5 PHR) | GBL |
| Example 56 | (PHA-4) (100 PHR) | present (3.8 PHR) | (b-2) (5 PHR) | - | (c-1) 42 PHR | (c-2) 14 PHR | (c-3) 14 PHR | - | - | - | (d-2) (0.5 PHR) | GBL |
| Example 57 | (PAA-3) (100 PHR) | present (7 PHR) | (b-2) (5 PHR) | - | (c-1) 42 PHR | (c-2) 14 PHR | (c-3) 14 PHR | - | - | - | (d-2) (0.5 PHR) | GBL |
| Example 58 | (PAA-3) (100 PHR) | present (15 PHR) | (b-2) (5 PHR) | - | (c-1) 42 PHR | (c-2) 14 PHR | (c-3) 14 PHR | - | - | - | (d-2) (0.5 PHR) | GBL |
| Example 59 | (PAA-3) (100 PHR) | present (20 PHR) | (b-2) (5 PHR) | - | (c-1) 42 PHR | (c-2) 14 PHR | (c-3) 14 PHR | - | - | - | (d-2) (0.5 PHR) | GBL |
| Comparative Example 1 | (PI-1) (100 PHR) | - | - | OXE 02 (5 PHR) | - | - | - | - | (c-4) 70 PHR | (d-1) (1.5 PHR) | - | GBL |

The abbreviations used in the above Tables 1 and 2-1 to 2-3 are as follows.

Component (A)

(PAA-1) to (PAA-12): the above-described polyimide precursors
(PHA-1) to (PHA-4): the above-described polybenzoxazole precursors
(PI-1): the above-described polyimide

Component (B)

(b-1): "IRGACURE" (registered trademark) 819 (manufactured by BASF Ltd.) (having a photobleaching property). Note that (b-1) does not correspond to the component (B) represented by Formula (1).
(b-2): NCI-930 (manufactured by ADEKA Corporation) (having a photobleaching property). Note that (b-2) corresponds to the component (B) represented by Formula (1).

Photopolymerization Initiator Other Than Component (B)

"IRGACURE" (registered trademark) OXE 02 (manufactured by BASF Ltd.) (not having a photobleaching property); abbreviated as "OXE 02" in Table 2-3.

Component (C)

(c-1): NK ESTER 4G (manufactured by Shin Nakamura Chemical Co., Ltd.)

When a polymer of the component (c-1) was heated from room temperature to 380°C at a heating rate of 10°C/min in a nitrogen atmosphere using a thermogravimetric analyzer, the residual rate after 1-hour heat treatment at 380°C was 3% by mass.
It is noted here that (c-1) corresponds to the component (C-1) represented by Formula (2).

(c-2): LIGHT ESTER EG (manufactured by Kyoeisha Chemical Co., Ltd.)

When a polymer of the component (c-2) was heated from room temperature to 380°C at a heating rate of 10°C/min in a nitrogen atmosphere using a thermogravimetric analyzer, the residual rate after 1-hour heat treatment at 380°C was 9% by mass.
It is noted here that (c-2) corresponds to the component (C-2) represented by Formula (3).
(c-3): "KARENZ MOI-BP" (registered trademark) (manufactured by Showa Denko K.K.)
When a polymer of the component (c-3) was heated from room temperature to 380°C at a heating rate of 10°C/min in a nitrogen atmosphere using a thermogravimetric analyzer, the residual rate after 1-hour heat treatment at 380°C was 17% by mass.
It is noted here that (c-3) corresponds to the component (C-3) having a blocked isocyanate structure.
(c-4): "LIGHT ACRYLATE" (registered trademark) DCP-A (manufactured by Kyoeisha Chemical Co., Ltd.)
When a polymer of the component (c-4) was heated from room temperature to 380°C at a heating rate of 10°C/min in a nitrogen atmosphere using a thermogravimetric analyzer, the residual rate after 1-hour heat treatment at 380°C was 26% by mass.
It is noted here that (c-4) does not correspond to any of the components (C-1) to (C-4).
(c-5): NK ESTER 14G (manufactured by Shin Nakamura Chemical Co., Ltd.)
When a polymer of the component (c-5) was heated from room temperature to 380°C at a heating rate of 10°C/min in a nitrogen atmosphere using a thermogravimetric analyzer, the residual rate after 1-hour heat treatment at 380°C was 0.9% by mass.
It is noted here that (c-5) corresponds to the component (C-4) represented by Formula (23).
(c-6): dipentaerythritol hexaacrylate (manufactured by Tokyo Chemical Industry Co., Ltd.)
When a polymer of the component (c-6) was heated from room temperature to 380°C at a heating rate of 10°C/min in a nitrogen atmosphere using a thermogravimetric analyzer, the residual rate after 1-hour heat treatment at 380°C was 69% by mass.
It is noted here that (c-6) does not correspond to any of the components (C-1) to (C-4).

Component (D)

(d-1): N-phenyldiethanolamine (manufactured by Tokyo Chemical Industry Co., Ltd.)
(d-2): DETX-S (manufactured by Nippon Kayaku Co., Ltd.)
Solvent: GBL (manufactured by Tokyo Chemical Industry Co., Ltd.)

The properties of the obtained varnishes were measured by the above-described evaluation methods. The table below shows the evaluation results of the i-line transmittance of prebaked film having a standard thickness of 5 μm, the sensitivity, the pattern shape, the developer adhesion, the storage stability, and the 5% weight loss temperature.

[Table 3]

| | i-line transmittance of prebaked film having a standard thickness of 5um (%) | Sensitivity ($mJ/cm^2$) | Pattern Shape Evaluation | Development Adhesiveness Evaluation (μm) | Storage Styability Evaluation | Temperature of 5% Heat Weigt Loss (°C) |
|---|---|---|---|---|---|---|
| Example 1 | 27 | 1200 | E | 30 | D | 475 |
| Example 2 | 32 | 600 | C | 20 | D | 470 |
| Example 3 | 35 | 550 | C | 20 | D | 468 |
| Example 4 | 32 | 450 | C | 20 | D | 465 |
| Example 5 | 32 | 400 | C | 20 | C | 469 |
| Example 6 | 32 | 300 | C | 20 | C | 466 |
| Example 7 | 32 | 350 | B | 20 | C | 465 |
| Example 8 | 32 | 350 | A | 20 | C | 463 |
| Example 9 | 35 | 350 | A | 20 | B | 462 |
| Example 10 | 35 | 350 | A | 20 | A | 466 |
| Example 11 | 30 | 200 | A | 20 | B | 460 |
| Example 12 | 35 | 400 | A | 20 | A | 455 |
| Example 13 | 35 | 350 | A | 15 | A | 453 |
| Example 14 | 35 | 400 | A | 15 | A | 452 |
| Example 15 | 20 | 500 | D | 30 | C | 480 |
| Example 16 | 25 | 1200 | E | 30 | D | 505 |
| Example 17 | 27 | 700 | D | 30 | D | 508 |
| Example 18 | 33 | 500 | B | 20 | D | 468 |
| Example 19 | 32 | 400 | D | 20 | D | 450 |
| Example 20 | 25 | 650 | C | 30 | D | 510 |
| Example 21 | 24 | 600 | B | 30 | D | 510 |
| Example 22 | 24 | 550 | D | 30 | D | 508 |
| Example 23 | 23 | 500 | D | 30 | D | 505 |
| Example 24 | 35 | 600 | C | 20 | D | 495 |
| Example 25 | 33 | 550 | B | 20 | D | 505 |
| Example 26 | 32 | 500 | B | 20 | D | 500 |
| Example 27 | 32 | 450 | D | 20 | D | 490 |
| Example 28 | 25 | 650 | C | 30 | D | 515 |

(continued)

| | i-line transmittance of prebaked film having a standard thickness of 5um (%) | Sensitivity (mJ/cm$^2$) | Pattern Shape Evaluation | Development Adhesiveness Evaluation (μm) | Storage Styability Evaluation | Temperature of 5% Heat Weigt Loss (°C) |
|---|---|---|---|---|---|---|
| Example 29 | 24 | 600 | C | 30 | D | 525 |
| Example 30 | 24 | 550 | C | 30 | D | 520 |
| Example 31 | 23 | 500 | D | 30 | D | 505 |
| Example 32 | 30 | 650 | C | 20 | D | 512 |
| Example 33 | 28 | 300 | E | 20 | D | 450 |
| Example 34 | 27 | 700 | C | 30 | D | 530 |
| Example 35 | 25 | 350 | E | 30 | D | 465 |
| Example 36 | 33 | 450 | D | 20 | C | 470 |
| Example 37 | 30 | 400 | D | 20 | C | 455 |
| Example 38 | 27 | 550 | D | 30 | D | 505 |
| Example 39 | 26 | 500 | C | 30 | D | 503 |
| Example 40 | 26 | 400 | C | 30 | D | 495 |
| Example 41 | 24 | 500 | D | 30 | D | 490 |
| Example 42 | 32 | 350 | A | 20 | C | 461 |
| Example 43 | 32 | 400 | C | 20 | C | 460 |
| Example 44 | 26 | 500 | C | 30 | D | 501 |
| Example 45 | 25 | 500 | B | 30 | D | 500 |
| Example 46 | 23 | 450 | B | 30 | D | 495 |
| Example 47 | 23 | 550 | C | 30 | D | 494 |
| Example 48 | 35 | 350 | A | 20 | C | 463 |
| Example 49 | 35 | 150 | C | 30 | A | 465 |
| Example 50 | 26 | 350 | A | 30 | C | 503 |
| Example 51 | 26 | 400 | A | 30 | B | 505 |
| Example 52 | 26 | 400 | A | 30 | A | 505 |
| Example 53 | 26 | 200 | C | 40 | A | 504 |
| Example 54 | 25 | 450 | A | 20 | A | 450 |
| Example 55 | 24 | 450 | A | 15 | A | 503 |
| Example 56 | 18 | 500 | A | 15 | A | 494 |
| Example 57 | 35 | 350 | A | 15 | A | 466 |
| Example 58 | 35 | 350 | A | 10 | A | 466 |
| Example 59 | 35 | 350 | A | 25 | B | 466 |
| Comparative Example 1 | 4 | 1,000 | F | 30 | C | 424 |

From the results shown above, it is demonstrated that the resin compositions of Examples have a high i-line (wavelength: 365 nm) transmittance and enable the processing of the pattern shape into a rectangle even in thick film processing. In Comparative Example 1, undercutting was observed in the pattern shape.

Industrial Applicability

A cured article of the negative photosensitive resin composition of the present invention can be preferably utilized for applications such as surface protective films of semiconductor elements, interlayer insulating films, wiring protective insulating films of circuit boards, and permanent resists.

## Claims

**1.** A negative photosensitive resin composition, comprising:

(A) an alkali-soluble resin;
(B) a photopolymerization initiator having a photobleaching property;
(C) a polymerizable compound; and
(D) a sensitizer,

wherein the alkali-soluble resin (A) contains at least one resin selected from the group consisting of (A-1) a polyimide precursor, (A-2) a polybenzoxazole precursor, and (A-3) a copolymer thereof.

**2.** The negative photosensitive resin composition according to claim 1,
wherein the alkali-soluble resin (A) contains a fluorine atom in an amount of 2 parts by mass to 50 parts by mass with respect to 100 parts by mass of the alkali-soluble resin (A).

**3.** The negative photosensitive resin composition according to claim 1 or 2,
wherein the photopolymerization initiator having a photobleaching property (B) has a structure represented by the following Formula (1):

[Chem. 1]

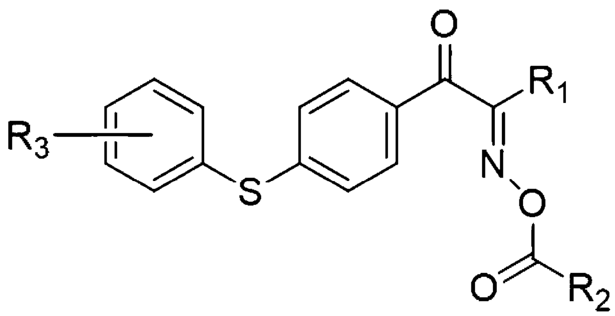

(1)

(in Formula (1), $R_1$ and $R_2$ each independently represent an alkyl group having 1 to 12 carbon atoms, a cycloalkyl group having 4 to 10 carbon atoms, a phenyl group, or a tolyl group; and $R_3$ represents an alkyl group having 0 to 5 carbon atoms, -OH, -COOH, $-O(CH_2)OH$, $-O(CH_2)_2OH$, $-COO(CH_2)OH$, or - $COO(CH_2)_2OH$).

**4.** The negative photosensitive resin composition according to claim 1 or 2,
wherein

the polymerizable compound (C) contains (C-1) a polyethylene glycol dimethacrylate represented by the following Formula (2) and (C-2) a polyethylene glycol dimethacrylate represented by the following Formula (3), and
the content of the polyethylene glycol dimethacrylate (C-2) represented by the following Formula (3) is 4 to 20 parts by mass with respect to 100 parts by mass of the polyethylene glycol dimethacrylate (C-1) represented by the following Formula (2):

[Chem. 2]

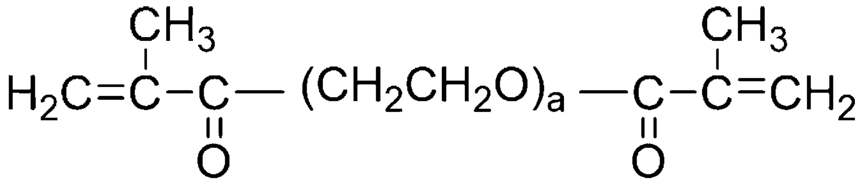
(2)

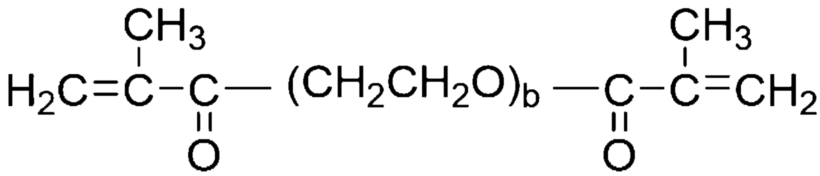
(3)

(in Formula (2), a represents an integer of 4 to 9; and, in Formula (3), b represents an integer of 1 to 3).

**5.** The negative photosensitive resin composition according to claim 1 or 2,
wherein

the polymerizable compound (C) contains (C-4) a polyethylene glycol dimethacrylate represented by the following Formula (23) and (C-2) a polyethylene glycol dimethacrylate represented by the following Formula (3), and
the content of the polyethylene glycol dimethacrylate (C-2) represented by the Formula (3) is 15 to 50 parts by mass with respect to 100 parts by mass of the polyethylene glycol dimethacrylate (C-4) represented by the Formula (23):

[Chem. 3]

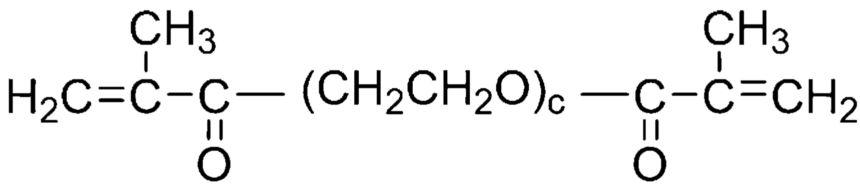
(23)

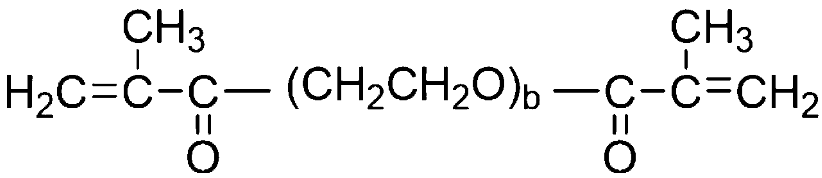
(3)

(in Formula (23), c represents an integer of 9 to 14; and, in Formula (3), b represents an integer of 1 to 3).

**6.** The negative photosensitive resin composition according to claim 1 or 2, wherein, when a polymer of the polymerizable compound (C) is heated from room temperature to 380°C at a heating rate of 10°C/min in a nitrogen atmosphere using a thermogravimetric analyzer, a residual rate after 1-hour heat treatment at 380°C is 10% by mass or less.

**7.** The negative photosensitive resin composition according to claim 1 or 2,
wherein

the polymerizable compound (C) contains (C-3) a polymerizable compound having a blocked isocyanate structure, and
the content of the polymerizable compound having a blocked isocyanate structure (C-3) is 0.5 to 15 parts by mass

with respect to 100 parts by mass of the (A) alkali-soluble resin.

**8.** The negative photosensitive resin composition according to claim 1 or 2, wherein

the sensitizer (D) contains (D-1) a thioxanthone-based sensitizer, and
the content of the thioxanthone-based sensitizer (D-1) is 5 to 30 parts by mass with respect to 100 parts by mass of the photopolymerization initiator having a photobleaching property (B).

**9.** The negative photosensitive resin composition according to claim 1 or 2, wherein the alkali-soluble resin (A) contains a resin containing a repeating structural unit of (A-1) a polyimide precursor represented by the following Formula (4):

[Chem. 4]

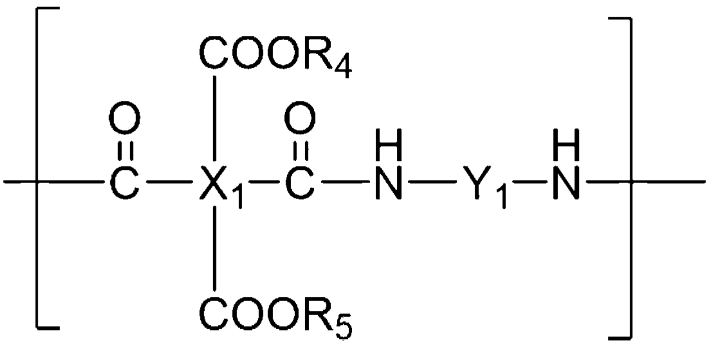

(4)

(in Formula (4), $X_1$ represents a tetravalent organic group having an aliphatic structure having 2 to 20 carbon atoms, an alicyclic structure having 4 to 20 carbon atoms, or an aromatic structure having 4 to 40 carbon atoms; $Y_1$ represents a divalent organic group having a fluorine atom-containing aliphatic structure having 2 to 20 carbon atoms, an alicyclic structure having 4 to 20 carbon atoms, or an aromatic structure having 4 to 40 carbon atoms; plural $R_4$s and $R_5$s are each optionally the same or different; and $R_4$ and $R_5$ each independently represent a hydrogen atom, an alkyl group having 1 to 20 carbon atoms, or an ethylene-type unsaturated double bond-containing monovalent organic group).

**10.** The negative photosensitive resin composition according to claim 9, wherein

the alkali-soluble resin (A) contains the repeating structural unit of the polyimide precursor (A-1) represented by the Formula (4), and
the polyimide precursor (A-1) represented by the Formula (4) has an esterification rate of 40% by mole to 80% by mole.

**11.** The negative photosensitive resin composition according to claim 1 or 2, wherein the alkali-soluble resin (A) contains a repeating structural unit of (A-2) a polybenzoxazole precursor represented by the following Formula (5):

[Chem. 5]

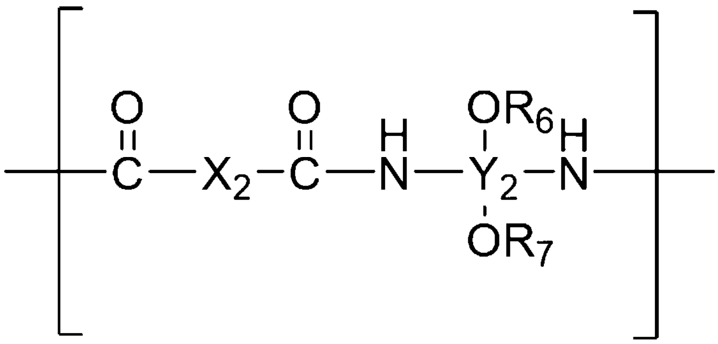

(5)

(in Formula (5), $X_2$ represents a divalent organic group having an aliphatic structure having 2 to 20 carbon atoms, an alicyclic structure having 4 to 20 carbon atoms, or an aromatic structure having 4 to 40 carbon atoms; $Y_2$ represents a tetravalent organic group having an aliphatic structure having 2 to 20 carbon atoms, an alicyclic structure having 4 to 20 carbon atoms, or an aromatic structure having 4 to 40 carbon atoms; at least one of $X_2$ or $Y_2$ has a fluorine atom; and $R_6$ and $R_7$ each independently represent a hydrogen atom, a monovalent alkyl group having 1 to 20 carbon atoms, or an ethylene-type unsaturated double bond-containing monovalent organic group).

**12.** The negative photosensitive resin composition according to claim 1 or 2, comprising a compound represented by the following Formula (6):

[Chem. 6]

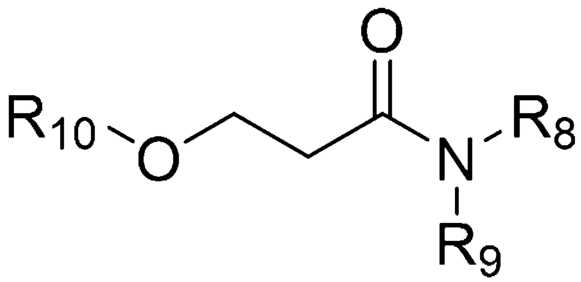

(6)

(in Formula (6), $R_8$, $R_9$, and $R_{10}$ each independently represent an alkyl group having 1 to 6 carbon atoms).

**13.** The negative photosensitive resin composition according to claim 9, wherein

in the Formula (4), $Y_1$ contains a structure represented by the following Formula (7) or a structure represented by the following Formula (8), and

a total content [% by mole] of the structure represented by Formula (7) and the structure represented by Formula (8) is in a range of 70% by mole to 100% by mole in 100% by mole of all diamine residues of the polyimide precursor (A-1) having the repeating structural unit represented by the Formula (4):

[Chem. 7]

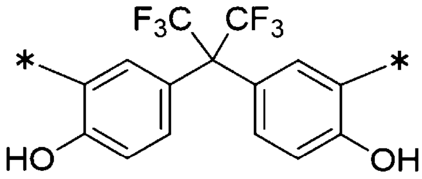

(7)

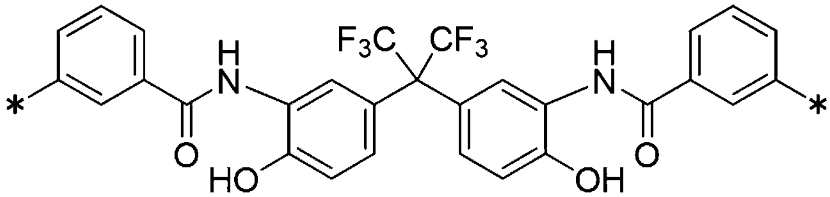

(8)

(in Formulae (7) and (8), * represents a binding site bound to an amide structure).

**14.** The negative photosensitive resin composition according to claim 11, wherein

in the Formula (5), $Y_2$ contains a structure represented by the following Formula (21) or a structure represented by the following Formula (22), and

a total content [% by mole] of the structure represented by Formula (21) and the structure represented by Formula (22) is in a range of 70% by mole to 100% by mole in 100% by mole of all diamine residues of the polybenzoxazole precursor (A-2) having the repeating structural unit represented by the Formula (5):

[Chem. 8]

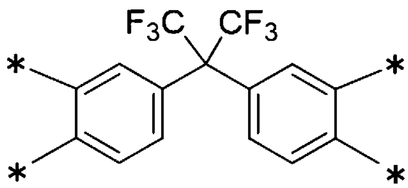

(21)

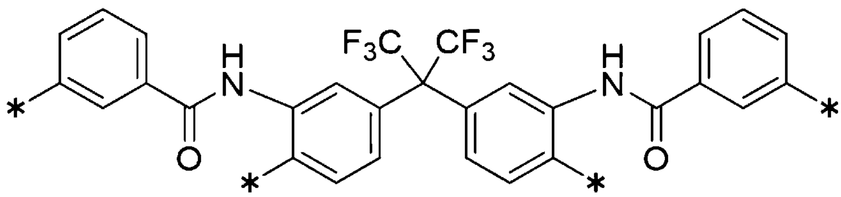

(22)

(in Formulae (21) and (22), * represents a binding site bound to an amide structure or an oxygen atom).

**15.** The negative photosensitive resin composition according to claim 9, wherein, in the Formula (4), $X_1$ contains a structure represented by the following Formula (9) or (10):

[Chem. 9]

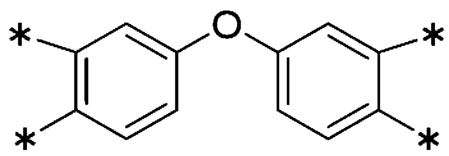

(9)

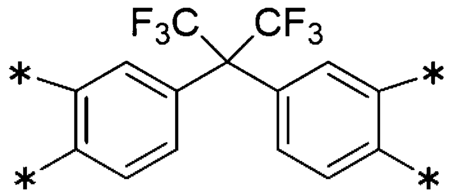

(10)

(in Formulae (9) and (10), * represents a binding site bound to an amide structure, a carboxylic acid structure, or a carboxylic acid ester structure).

**16.** The negative photosensitive resin composition according to claim 11,
wherein, in the Formula (5), $X_2$ contains a structure represented by the following Formula (11):

[Chem. 10]

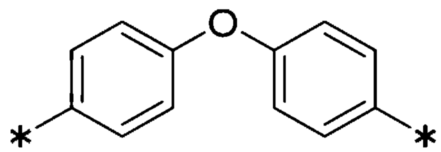

(11)

(in Formula (11), * represents a binding site bound to an amide structure).

**17.** A method for producing a relief pattern, the method comprising the steps of:

applying and drying the negative photosensitive resin composition according to claim 1 or 2 onto a substrate;
performing exposure;
performing development with an alkaline developer; and
performing a heat treatment.

**18.** A cured article, obtained by curing the negative photosensitive resin composition according to claim 1 or 2.

**19.** An electronic component, comprising the cured article according to claim 18.

**20.** The electronic component according to claim 19, comprising the cured article on a silicon substrate, a silicon carbide substrate, or a gallium nitride substrate.

# INTERNATIONAL SEARCH REPORT

International application No. **PCT/JP2024/001959**

## A. CLASSIFICATION OF SUBJECT MATTER

***G03F 7/038***(2006.01)i; ***C08G 73/10***(2006.01)i; ***C08G 73/22***(2006.01)i; ***G03F 7/027***(2006.01)i; ***G03F 7/032***(2006.01)i
FI: G03F7/038 504; G03F7/032; G03F7/027 502; C08G73/10; C08G73/22

According to International Patent Classification (IPC) or to both national classification and IPC

## B. FIELDS SEARCHED

Minimum documentation searched (classification system followed by classification symbols)

G03F7/038; C08G73/10; C08G73/22; G03F7/027; G03F7/032

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X | JP 2021-073487 A (DNP FINE CHEMICALS CO., LTD.) 13 May 2021 (2021-05-13) claims, examples | 1, 3, 8-9, 17-20 |
| Y | | 12 |
| A | | 2, 4-7, 10-11, 13-16 |
| X | WO 2020/196139 A1 (TORAY INDUSTRIES, INC.) 01 October 2020 (2020-10-01) claims, examples | 1-3, 6-10, 13, 15, 17-20 |
| Y | | 12 |
| A | | 4-5, 14, 16 |
| X | JP 2019-045865 A (TORAY INDUSTRIES, INC.) 22 March 2019 (2019-03-22) claims, examples | 1-2, 8-11, 13-20 |
| Y | | 12 |
| A | | 3-7 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 March 2024** | **19 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No. PCT/JP2024/001959

C. DOCUMENTS CONSIDERED TO BE RELEVANT

| Category* | Citation of document, with indication, where appropriate, of the relevant passages | Relevant to claim No. |
|---|---|---|
| Y | WO 2020/031958 A1 (TORAY INDUSTRIES, INC.) 13 February 2020 (2020-02-13) claims, examples, paragraph [0154] | 12 |

**INTERNATIONAL SEARCH REPORT**
**Information on patent family members**

International application No.
**PCT/JP2024/001959**

| Patent document cited in search report | Publication date (day/month/year) | Patent family member(s) | Publication date (day/month/year) |
|---|---|---|---|
| JP 2021-073487 A | 13 May 2021 | (Family: none) | |
| WO 2020/196139 A1 | 01 October 2020 | US 2022/0155684 A1<br>claims, examples<br>EP 3933906 A1<br>CN 113646882 A<br>KR 10-2021-0146882 A<br>SG 11202110343P A<br>TW 202102939 A | |
| JP 2019-045865 A | 22 March 2019 | US 2021/0011381 A1<br>claims, examples<br>TW 201730677 A<br>SG 11201802076P A<br>CN 108027561 A<br>KR 10-2018-0063060 A | |
| WO 2020/031958 A1 | 13 February 2020 | CN 112368641 A<br>KR 10-2021-0040936 A<br>TW 202018411 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 200698291 A
- JP 2008281597 A
- JP 2004307710 A
- JP 2008015285 A
- WO 2015036910 A